# EUROPEAN PATENT APPLICATION

(11) **EP 4 822 487 A1**
(43) Date of publication of application: **14.10.2026**
(21) Application number: 25738970.0
(22) Date of filing: 08.01.2025
(51) Int. Cl.: G06F 1/16

(54) **ELECTRONIC APPARATUS INCLUDING BELT**

(30) Priority: 08.01.2024 KR 20240002951; 26.01.2024 KR 20240012277
(71) Applicant: Samsung Electronics Co., Ltd., Suwon-si, Gyeonggi-do 16677 (KR)
(72) Inventor: CHO, Joongyeon, Suwon-si, Gyeonggi-do 16677 (KR)
(74) Representative: Gulde & Partner
(86) International application number: PCT/KR2025/000451
(87) International publication number: WO 2025/150897

(57) **Abstract**

An electronic apparatus according to an embodiment disclosed herein comprises: a housing that includes a first housing and a second housing movably coupled to the first housing; a flexible display which is at least partially supported by the second housing and has a display area that changes in response to the movement of the second housing relative to the first housing; a belt which has one end connected to the flexible display and the other end connected to the second housing; and a pulley that is in contact with at least a portion of the belt. The belt includes at least two metal sheets that overlap each other, and the at least two metal sheets may have different lengths.

## Description

### [Technical Field]

The disclosure relates to an electronic device including a belt.

### [Background Art]

An electronic device (e.g., a rollable electronic device) may include a first housing, a second housing movably coupled to the first housing, and a flexible display.

The electronic device may include a belt connecting the flexible display and a housing (e.g., the second housing). The belt may be connected to the display at one end and connected to a portion of the housing (e.g., the second housing) at an opposite end. The belt may be disposed such that at least a portion thereof is in contact with a pulley.

The above information may be provided as related art for the purpose of helping understanding of the present disclosure. Nothing described above is admitted as prior art related to the disclosure, or may be used to determine prior art.

### [Disclosure of Invention]

### [Technical Solution]

An electronic device according to an embodiment of the disclosure may include a housing, a flexible display, a belt, and a pulley.

In an embodiment, the housing may include a first housing and a second housing movably coupled to the first housing.

In an embodiment, the flexible display may be disposed to be at least partially supported by the second housing, and the display area of the flexible display may be variable according to movement of the second housing relative to the first housing.

In an embodiment, the belt may be connected to the flexible display at one end and connected to the second housing at an opposite end.

In an embodiment, the pulley may be disposed to be in contact with at least a portion of the belt.

In an embodiment, the belt may include at least two metal sheets disposed to overlap each other.

In an embodiment, the at least two metal sheets may have different lengths from each other.

A belt structure according to an embodiment of the disclosure may include a belt, a pulley, a first fixing member, and a second fixing member.

In an embodiment, the first fixing member may be coupled to the belt at one end of the belt.

In an embodiment, the second fixing member may be coupled to the belt at an opposite end of the belt.

In an embodiment, the at least two metal sheets may be formed such that lengths thereof extending between the first fixing member and the second fixing member differ from each other.

### [Brief Description of Drawings]

FIG. 1 is a block diagram of an electronic device in a network environment according to an embodiment.
FIGS. 2A and 2B are views illustrating an electronic device according to an embodiment of the disclosure in a slide-in state.
FIGS. 3A and 3B are views illustrating the electronic device according to an embodiment of the disclosure in a slide-out state.
FIG. 4 is an exploded perspective view illustrating an electronic device according to an embodiment of the disclosure.
FIGS. 5A, 5B, and 5B are cross-sectional views illustrating an electronic device according to an embodiment of the disclosure.
FIG. 6 is an exploded perspective view illustrating an electronic device according to an embodiment of the disclosure.
FIGS. 7A and 7B are views illustrating a second housing and a belt according to an embodiment of the disclosure in a slide-in state.
FIGS. 8A and 8B are views illustrating the second housing and the belt according to an embodiment of the disclosure in a slide-out state.
FIG. 9 is a view illustrating a belt according to an embodiment of the disclosure.
FIG. 10 is a view illustrating a belt including a first bent portion and a second bent portion according to an embodiment of the disclosure.
FIG. 11 is a view illustrating a belt and a pulley according to an embodiment of the disclosure.
FIG. 12 is a view illustrating a belt and fixing members according to an embodiment of the disclosure.
FIG. 13 is a view illustrating a pulley and plates according to an embodiment of the disclosure.
FIG. 14 is a view illustrating a plate to be disposed on a pulley according to an embodiment of the disclosure.
FIG. 15 is a view illustrating a belt, a pulley, and plates according to an embodiment of the disclosure.
FIGS. 16A, 16B, and 16C are views illustrating a first fixing member and a first seating portion according to an embodiment of the disclosure.
FIGS. 17A, 17B, and 17C are views illustrating a second fixing member and a second seating portion according to an embodiment of the disclosure.

### [Mode for the Invention]

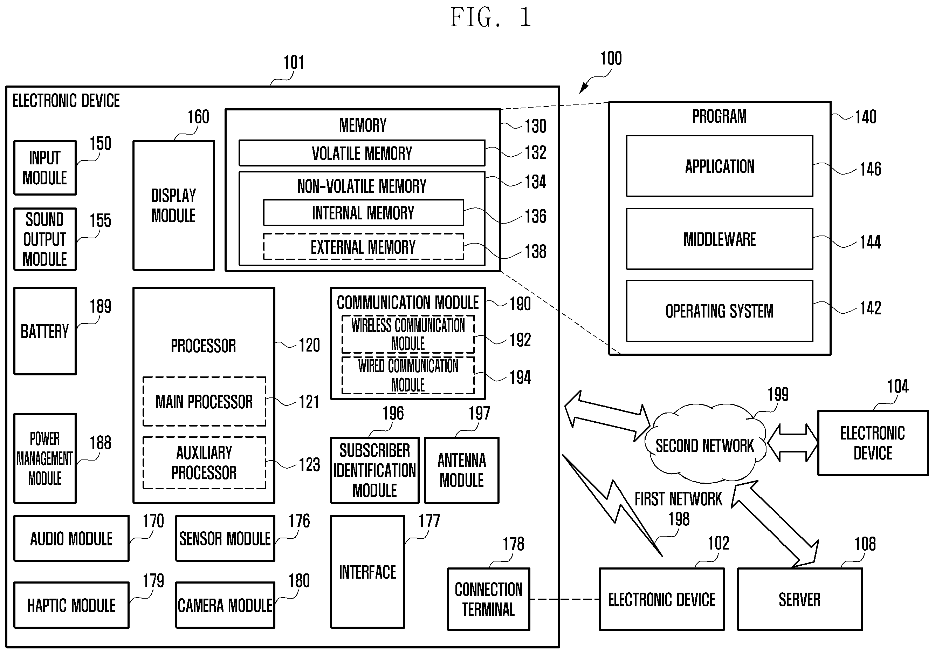

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

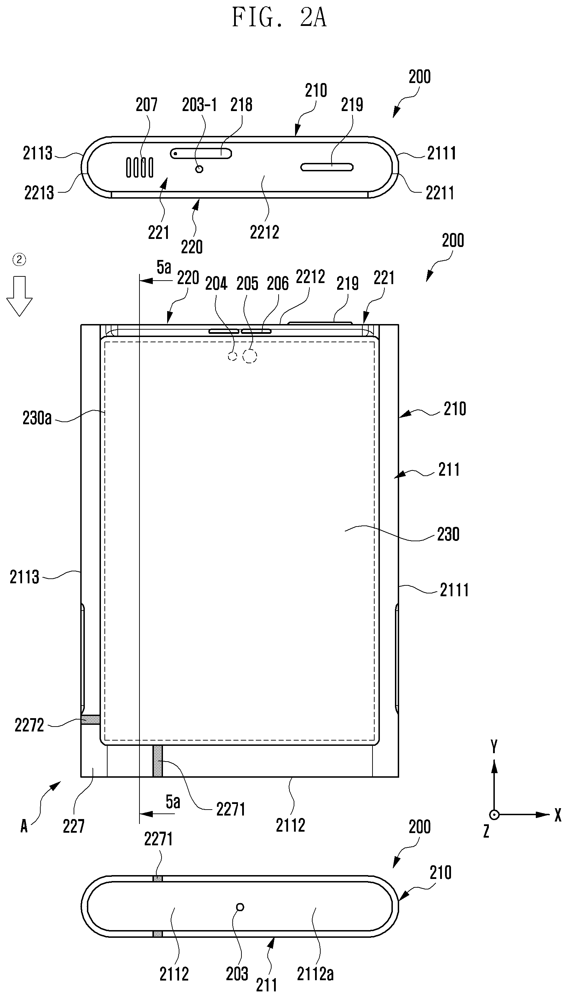

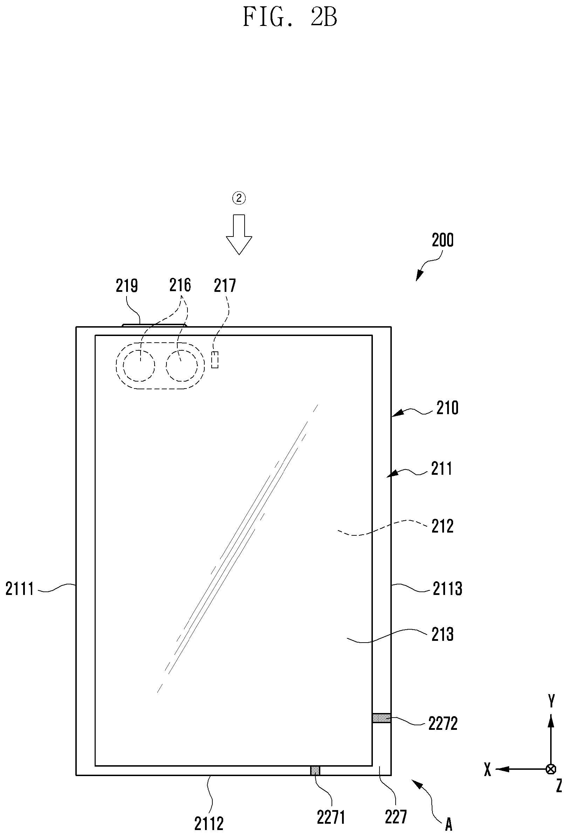

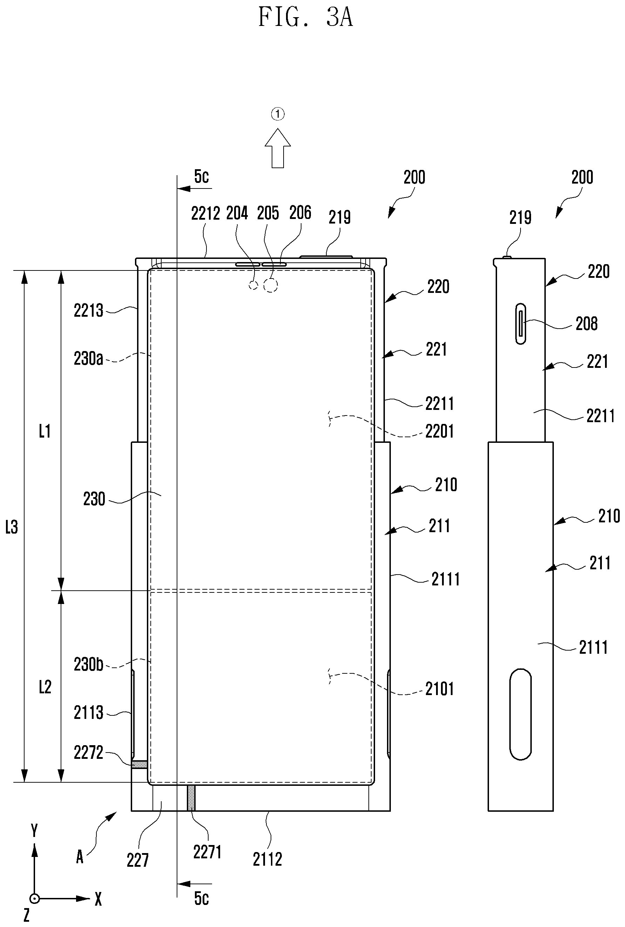

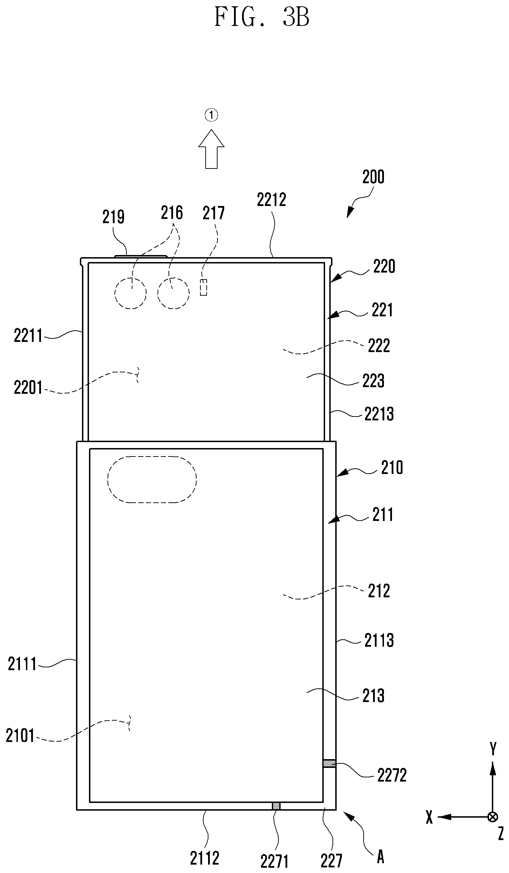

FIGS. 2A and 2B are views illustrating the front surface and the rear surface of an electronic device in a slide-in state according to an embodiment of the disclosure. FIGS. 3A and 3B are views illustrating the front surface and the rear surface of the electronic device in a slide-out state according to an embodiment of the disclosure.

The electronic device 200 of FIGS. 2A to 3B may refer to the electronic device 101 of FIG. 1 or may include at least some of the components of the electronic device 101 of FIG. 1.

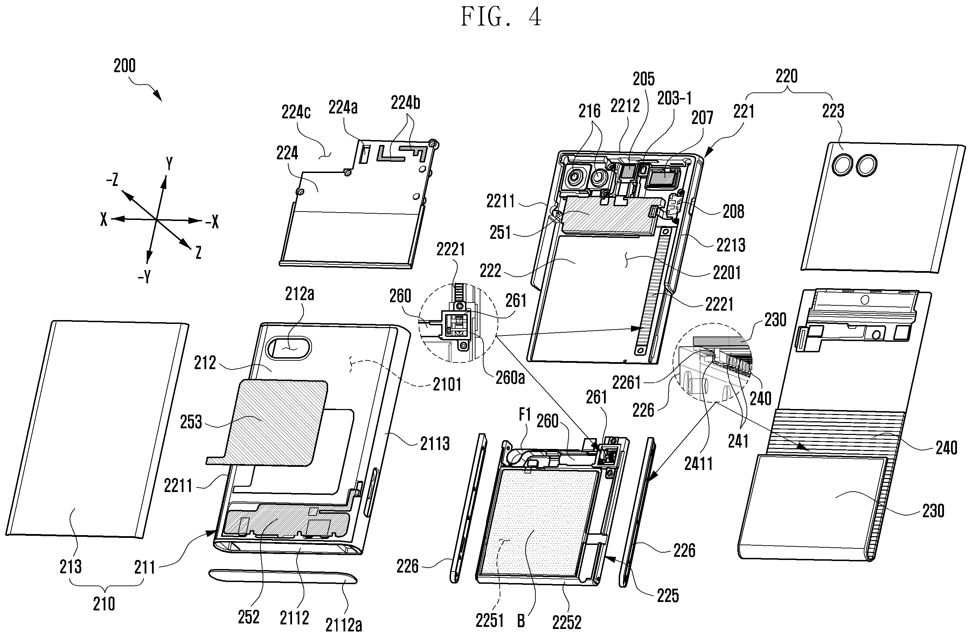

Referring to FIGS. 2A to 3B, the electronic device 200 may include a first housing 210, a second housing 220 slidably coupled to the first housing 210 so as to slide in a predetermined direction (e.g., direction ① or direction ②) (e.g., the ±y-axis direction) from the first housing 210, and a rollable display 230 (e.g., a flexible display, an expandable display, or a stretchable display) disposed to be supported by at least a portion of the first housing 210 and the second housing 220. In an embodiment, the second housing 220 may be slidably coupled to the first housing 210 so as to be slid out in a first direction (direction ①) or slid in in a second direction (direction ②), which is opposite to the first direction (direction ①), with respect to the first housing 210. In an embodiment, the electronic device 200 may be transitioned to the slide-in state (e.g., an inserted state) as the second housing 220 is at least partially accommodated in at least a portion of a first space 2101 formed in the first housing 210. In an embodiment, the electronic device 200 may be changed to the slide-out state (e.g., a slid-out state) as the second housing 220 is at least partially moved to the outside (e.g., in direction η) from the first space 2101. In an embodiment, the electronic device 200 may include a support member (e.g., the support member 240 of FIG. 4) (e.g., a bendable member, a bendable support member, a multi-joint hinge module, or a multi-bar assembly) that at least partially forms, in the slide-out state, the same plane as at least a portion of the second housing 220 and is at least partially accommodated, in the slide-in state, in the first space 2101 of the first housing 210 in a bending manner. In an embodiment, at least a portion of the rollable display 230 may be disposed to be attached to at least a portion of the second housing 220. In an embodiment, at least a portion of the remaining portion of the rollable display 230 may be attached to the support member 240 (e.g., the support member 240 of FIG. 4). In an embodiment, at least a portion of the rollable display 230 may be disposed to be invisible from the outside by being accommodated, in the slide-in state, in the first space 2101 of the first housing 210 in a bending manner while being supported by the support member (e.g., the support member 240 of FIG. 4). In an embodiment, at least a portion of the rollable display 230 may be disposed to be visible from the outside, in the slide-out state, while being supported by the support member (e.g., the support member 240 of FIG. 4) that at least partially forms the same plane as the second housing 220.

According to an embodiment, the electronic device 200 may include a first housing 210 including a first side member 211 and a second housing 220 including a second side member 221. In an embodiment, the first side member 211 may include a first side surface 2111 having a first length along a first direction (e.g., the y-axis direction), a second side surface 2112 extending from the first side surface 2111 to have a second length shorter than the first length along a direction substantially perpendicular to the first side surface 2111 (e.g., the x-axis direction), and a third side surface 2113 extending from the second side surface 2112 substantially parallel to the first side surface 2111 and having the first length. In an embodiment, the first side member 211 may be at least partially formed of a conductive member (e.g., metal). In an embodiment, the first side member 211 may be formed by coupling a conductive member and a non-conductive member (e.g., polymer). In an embodiment, the first housing 210 may include a first extension member 212 extending from at least a portion of the first side member 211 to at least a portion of the first space 2101. In an embodiment, the first extension member 212 may be integrally formed with the first side member 211. In an embodiment, the first extension member 212 may be formed separately from the first side member 211 and may be structurally coupled to the first side member 211.

According to an embodiment, the second side member 221 may include a fourth side surface 2211 corresponding at least partially to the first side surface 2111 and having a third length, a fifth side surface 2212 extending from the fourth side surface 2211 in a direction substantially parallel to the second side surface 2112 and having a fourth length smaller than the third length, and a sixth side surface 2213 extending from the fifth side surface 2212 to correspond to the third side surface 2113 and having the third length. In an embodiment, the second side member 221 may be formed at least partially of a conductive member (e.g., metal). In an embodiment, the second side member 221 may be formed by coupling a conductive member and a non-conductive member (e.g., polymer). In an embodiment, at least a portion of the second side member 221 may include a second extension member 222 extending to at least a portion of a second space 2201 of the second housing 220. In an embodiment, the second extension member 222 may be integrally formed with the second side member 221. In an embodiment, the second extension member 222 may be formed separately from the second side member 221 and may be structurally coupled to the second side member 221.

According to an embodiment, the first side surface 2111 and the fourth side surface 2211 may be slidably coupled to each other. In an embodiment, the third side surface 2113 and the sixth side surface 2213 may be slidably coupled to each other. In an embodiment, in the slide-in state, the fourth side surface 2211 may be disposed to be substantially invisible from the outside by overlapping the first side surface 2111. In an embodiment, in the slide-in state, the sixth side surface 2213 may be disposed to be substantially invisible from the outside by overlapping the third side surface 2113. In an embodiment, at least a portion of the fourth side surface 2211 and the sixth side surface 2213 may be disposed to be at least partially visible from the outside in the slide-in state. In an embodiment, in the slide-in state, the second extension member 222 may be disposed to be substantially invisible from the outside by overlapping the first extension member 212. In an embodiment, the second extension member 222 may be disposed to be at least partially visible from the outside in the slide-in state.

According to an embodiment, the first housing 210 may include a first rear surface cover 213 coupled to at least a portion of the first side member 211. In an embodiment, the first rear surface cover 213 may be disposed to be coupled to at least a portion of the first extension member 212. In an embodiment, the first rear surface cover 213 may be integrally formed with the first side member 211. In an embodiment, the first rear surface cover 213 may be formed of polymer, coated or colored glass, ceramic, metal (e.g., aluminum, stainless steel (STS), or magnesium), or a combination of at least two of these materials. In an embodiment, the first rear surface cover 213 may extend to at least a portion of the first side member 211. In an embodiment, the first rear surface cover 213 may be omitted, and at least a portion of the first extension member 212 may be replaced by the first rear surface cover 213.

According to an embodiment, the second housing 220 may include a second rear surface cover 223 coupled to at least a portion of the second side member 221. In an embodiment, the second rear surface cover 223 may be disposed to be coupled to at least a portion of the second extension member 222. In an embodiment, the second rear surface cover 223 may be integrally formed with the second side member 221. In an embodiment, the second rear surface cover 223 may be formed of polymer, coated or colored glass, ceramic, metal (e.g., aluminum, stainless steel (STS), or magnesium), or a combination of at least two of these materials. In an embodiment, the second rear surface cover 223 may extend to at least a portion of the second side member 221. In an embodiment, the second rear surface cover 223 may be omitted, and at least a portion of the second extension member 222 may be replaced by the second rear surface cover 223.

According to an embodiment, the rollable display 230 may include a first portion 230a (e.g., a flat portion) always visible from the outside and a second portion 230b (e.g., a bendable portion or a bending portion) extending from the first portion 230a and accommodated in the first space 2101 of the first housing 210 in a manner of being at least partially bent so as to be invisible from the outside in the slide-in state. In an embodiment, the first portion 230a may be disposed to be supported by the second housing 220, and the second portion 230b may be disposed to be at least partially supported by the support member (e.g., the support member 240 of FIG. 4). In an embodiment, the second portion 230b of the rollable display 230 may be disposed, when the second housing 220 is in the slide-out state along the first direction (direction ①), to form substantially the same plane as the first portion 230a while being supported by the support member (e.g., the support member 240 of FIG. 4), and to be visible from the outside. In an embodiment, the second portion 230b of the rollable display 230 may be accommodated, when the second housing 220 is in the slide-in state along the second direction (direction ②), in the first space 2101 of the first housing 210 in a manner of being bent, and may be disposed so as to be invisible from the outside. Accordingly, the display area of the rollable display 230 may be variable according to the movement of the second housing 220 in a sliding manner from the first housing 210 along a predetermined direction (e.g., the ±y-axis direction).

According to an embodiment, the length of the rollable display 230 in the first direction (direction ①) may be variable according to sliding movement of the second housing 220 with respect to the first housing 210. For example, the rollable display 230 may have, in the slide-in state, a first display area (e.g., an area corresponding to the first portion 230a) corresponding to a first length L1. In an embodiment, the rollable display 230 may be expanded, in the slide-out state, according to sliding movement of the second housing 220 additionally moved by a second length L2 with respect to the first housing 210, so as to have a third length L3 greater than the first length L1 and a second display area (e.g., an area including the first portion 230a and the second portion 230b) greater than the first display area.

According to an embodiment, the electronic device 200 may include at least one of an input device (e.g., the microphone 203-1), an audio output device (e.g., the receiver 206 for a call and/or the speaker 207), sensor modules 204 and 217, a camera module (e.g., the first camera module 205 or the second camera module 216), a connector port 208, a key input device 219, or an indicator (not illustrated), disposed in the second space 2201 of the second housing 220. In an embodiment, the electronic device 200 may include another input device (e.g., the microphone 203) disposed in the first housing 210. In an embodiment, the electronic device 200 may be configured such that at least one of the above-described components is omitted or other components are additionally included. In an embodiment, at least one of the above-described components may be disposed in the first space 2101 of the first housing 210.

According to an embodiment, the input device may include a microphone 203-1. In an embodiment, the input device (e.g., the microphone 203-1) may include a plurality of microphones disposed to detect a direction of a sound. The audio output device may include, for example, a receiver 206 for a call and a speaker 207. In an embodiment, the speaker 207 may correspond to the outside through at least one speaker hole formed in the second housing 220 at a position (e.g., the fifth side surface 2212) always exposed to the outside regardless of the slide-in state or the slide-out state. In an embodiment, the connector port 208 may correspond to the outside through a connector port hole formed in the second housing 220 in the slide-out state. In an embodiment, the connector port 208 may correspond to the outside in the slide-in state through an opening formed in the first housing 210 and formed to correspond to the connector port hole. In an embodiment, the receiver 206 for a call may include an operating speaker (e.g., a piezo speaker) without a separate speaker hole.

According to an embodiment, the sensor modules 204 and 217 may generate an electrical signal or a data value corresponding to an operating state inside the electronic device 200 or an environmental state outside the electronic device 200. In an embodiment, the sensor modules 204 and 217 may include, for example, a first sensor module 204 (e.g., a proximity sensor or an illuminance sensor) disposed on the front surface of the electronic device 200 and/or a second sensor module 217 (e.g., an HRM (heart rate monitoring) sensor) disposed on the rear surface of the electronic device 200. In an embodiment, the first sensor module 204 may be disposed below the rollable display 230 on the front surface of the electronic device 200. In an embodiment, the first sensor module 204 and/or the second sensor module 217 may include at least one of a proximity sensor, an illuminance sensor, a time-of-flight (TOF) sensor, an ultrasonic sensor, a fingerprint recognition sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, or a humidity sensor.

According to an embodiment, the camera module may include a first camera module 205 disposed on the front surface of the electronic device 200 and a second camera module 216 disposed on the rear surface of the electronic device 200. In an embodiment, the electronic device 200 may further include a flash (not illustrated) positioned near the second camera module 216. In an embodiment, the camera modules 205 and 216 may include one or more lenses, an image sensor, and/or an image signal processor. In an embodiment, the first camera module 205 may be disposed below the rollable display 230 and may be configured to capture a subject through a portion of an activated area (e.g., a display area) of the rollable display 230.

According to an embodiment, the first camera module 205 among the camera modules and some sensor modules 204 among the sensor modules 204 and 217 may be disposed to detect an external environment through the rollable display 230. For example, the first camera module 205 or some sensor modules 204 may be disposed in the second space 2201 of the second housing 220 so as to contact the external environment through a transmission area or a perforated opening formed in the rollable display 230. In an embodiment, the area of the rollable display 230 facing the first camera module 205 may be formed as a transmission area having a predetermined transmittance, as a portion of an activated area displaying content. In an embodiment, the transmission area may be formed to have a transmittance in a range of about 5% to about 20%. The transmission area may include an area overlapping an effective area (e.g., an angle-of-view area) of the first camera module 205, through which light passes to be imaged on the image sensor and generate an image. For example, the transmission area of the rollable display 230 may include an area having a lower arrangement density of pixels and/or a lower wire density than surrounding areas. For example, the transmission area may be replaced by the above-described opening. For example, some camera modules 205 may include an under-display camera (UDC). In an embodiment, some sensor modules 204 may be disposed in the second space 2201 of the second housing 220 so as to perform a function thereof without being visually exposed through the rollable display 230.

According to an embodiment, the electronic device 200 may include at least one antenna element (e.g., the antenna element 224b of FIG. 4) electrically connected to wireless communication circuitry (e.g., the wireless communication module 192 of FIG. 1) disposed in an inner space (e.g., the second space 2201 of the second housing 220). In an embodiment, the electronic device 200 may further include a bezel antenna A disposed through at least a portion of the conductive first side member 211 of the first housing 210. For example, the bezel antenna A may be disposed through at least a portion of the second side surface 2112 and the third side surface 2113 of the first side member 211, and may include a conductive portion 227 (e.g., a conductive member) electrically segmented through one or more segmentation portions 2271 and 2272 formed of a non-conductive material (e.g., polymer). In an embodiment, the wireless communication circuitry (e.g., the wireless communication module 192 of FIG. 1) may be configured to transmit or receive a wireless signal in at least one predetermined frequency band (e.g., about 600 MHz to 9000 MHz) (e.g., a legacy band or an NR band) through the conductive portion 227. In an embodiment, the electronic device 200 may include a side surface cover 2112a disposed on the second side surface 2112 to cover at least a portion of the at least one segmentation portion 2271. In some embodiments, the bezel antenna A may be disposed on at least one of the first side surface 2111, the second side surface 2112, or the third side surface 2113. In some embodiments, the bezel antenna A may be disposed on at least one of the fourth side surface 2211, the fifth side surface 2212, or the sixth side surface 2213 of the second housing 220. In some embodiments, the electronic device 200 may further include at least one antenna module (e.g., an mmWave antenna module or an mmWave antenna structure) disposed in an inner space (e.g., the first space 2101 or the second space 2201) and disposed to transmit or receive a wireless signal in a frequency band in a range of about 3 GHz to 100 GHz through another wireless communication circuitry (e.g., the wireless communication module 192 of FIG. 1).

According to an embodiment, a slide-in/slide-out operation of the electronic device 200 may be automatically performed. For example, the slide-in/slide-out operation of the electronic device 200 may be performed through gear coupling between a driving motor (e.g., the driving motor 260 of FIG. 4) including a pinion gear (e.g., the pinion gear 261 of FIG. 4) disposed in the first space 2101 of the first housing 210 and a rack gear (e.g., the rack gear 2221 of FIG. 4) disposed in the second space 2201 of the second housing 220 and meshed with the pinion gear 261. In some embodiment, the driving motor 260 including the pinion gear 261 may be disposed in the second space 2201 of the second housing 220, and the rack gear 2221 meshed with the pinion gear 261 may be disposed in the first space 2101 of the first housing 210. For example, when detecting a triggering signal for transitioning from the slide-in state to the slide-out state or from the slide-out state to the slide-in state, the processor of the electronic device 200 (e.g., the processor 120 of FIG. 1) may operate a driving motor (e.g., the driving motor 260 of FIG. 4) disposed inside the electronic device 200. In an embodiment, the triggering signal may include a signal according to selection (e.g., touch) of an object displayed on the rollable display 230 or a signal according to manipulation of a physical button (e.g., a key button) included in the electronic device 200. In an embodiment, the slide-in/slide-out operation of the electronic device 200 may be manually performed through user manipulation.

According to an embodiment, the electronic device 200 has a structure in which the second housing 220 is slid in and/or slid out with respect to the first housing 210 along a length direction (e.g., a vertical direction) (e.g., a ±y-axis direction) of the electronic device 200, but the disclosure is not limited thereto. For example, the electronic device 200 may have a structure in which the second housing 220 is slid in and/or slid out with respect to the first housing 210 along a width direction (e.g., a horizontal direction) (e.g., the ±x-axis direction) perpendicular to the length direction of the electronic device 200. In some embodiments, the electronic device 200 may be formed such that the length of the second side surface 2112 of the first housing 210 is greater than the length of the first side surface 2111. In this case, the length of the fifth side surface 2212 of the second housing 220 may also be formed correspondingly to be greater than the length of the fourth side surface 2211.

FIG. 4 is an exploded perspective view illustrating an electronic device according to an embodiment of the disclosure.

In describing the electronic device 200 of FIG. 4, the same reference numerals are assigned to components substantially identical to those of the electronic device 200 of FIGS. 2A to 3B, and a detailed description thereof may be omitted.

Referring to FIG. 4, the electronic device 200 may include a first housing 210 including a first space 2101, a second housing 220 slidably coupled to the first housing 210 and including a second space 2201, a support member 240 fixed to at least a portion of the second housing 220 and accommodated to be at least partially bendable into the first space 2101 according to a slide-in operation, a rollable display 230 disposed to be supported by at least a portion of the support member 240 and the second housing 220, and a driving module (e.g., a driving mechanism) configured to drive the second housing 220 from the first housing 210 in a slide-in direction (e.g., the -y-axis direction) and/or a slide-out direction (e.g., the y-axis direction). In an embodiment, the first housing 210 may include a first side member 211 and a first rear surface cover 213 coupled to at least a portion of the first side member 211 (e.g., at least a portion of the first extension member 212). In an embodiment, the second housing 220 may include a second side member 221 and a second rear surface cover 223 coupled to at least a portion of the second side member 221 (e.g., at least a portion of the second extension member 222). In an embodiment, the driving module may include a driving motor 260 disposed in the first space 2101 and including a pinion gear 261, and a rack gear 2221 disposed in the second space 2201 so as to be meshed with the pinion gear 261. In an embodiment, the driving module may further include a reducer module (e.g., a reducer gear assembly) disposed to reduce a rotational speed and increase driving force by being coupled to the driving motor 260. In an embodiment, the driving motor 260 may be disposed to be supported through a motor bracket 260a disposed on a support bracket 225 disposed in the first space 2101 of the first housing 210. In an embodiment, the driving motor 260 may be fixed, in the first space 2101, to an end portion (e.g., an edge) of the support bracket 225 in the slide-out direction (e.g., the y-axis direction). In an embodiment, the rack gear 2221 may be disposed to be fixed to the second extension member 222 of the second housing 220. In some embodiments, the rack gear 2221 may be integrally formed by being injection-molded on at least a portion of the second extension member 222. In an embodiment, the rack gear 2221 may be disposed to have a length in a direction parallel to a sliding direction (e.g., the ±y-axis direction). Accordingly, when the electronic device 200 is assembled, the pinion gear 261 may maintain a state of being meshed with the rack gear 2221, and the pinion gear 261 provided with driving force from the driving motor 260 may move along the rack gear 2221, and as a result, the second housing 220 may be moved with respect to the first housing 210. In an embodiment, the sliding distance of the second housing 220 may be determined by the length of the rack gear 2221.

According to an embodiment, the electronic device 200 may include a plurality of electronic components disposed in the second space 2201. In an embodiment, the plurality of electronic components may include a first substrate 251 (e.g., a main substrate), and a camera module 216 a speaker 207, a connector port 208, and a microphone 203-1 disposed around the first substrate 251. In an embodiment, because the plurality of electronic components are disposed around the first substrate 251 in the second space 2201 of the second housing 220, efficient electrical connection may be possible. In an embodiment, at least one of the above-described plurality of electronic components may be disposed in the first space 2101 of the first housing 210.

According to an embodiment, the electronic device 200 may include, in the second housing 220, a rear bracket 224 disposed between the second extension member 222 and the second rear surface cover 223. In an embodiment, the rear bracket 224 may be disposed to cover at least some of the plurality of electronic components. In an embodiment, the rear bracket 224 may be structurally coupled to at least a portion of the second extension member 222. In an embodiment, the rear bracket 224 may be omitted. In an embodiment, the rear bracket 224 may be disposed to cover the plurality of electronic components and support the second rear surface cover 223. In an embodiment, the rear bracket 224 may include an opening 224a (e.g., a through-hole) or a notch area 224c (e.g., a cutout portion) formed in an area corresponding to the camera module 216 and/or a sensor module (e.g., the sensor module 217 of FIG. 3B). In an embodiment, the rear bracket 224 may include at least one antenna element 224b. In an embodiment, when the rear bracket 224 is formed of an injection-molded dielectric material (e.g., an antenna carrier), the at least one antenna element 224b may be disposed on an outer surface of the rear bracket 224. In an embodiment, the at least one antenna element 224b may include a laser direct structuring (LDS) antenna pattern formed on the outer surface of the rear bracket 224. In an embodiment, the at least one antenna element 224b may include a conductive plate attached to the outer surface of the rear bracket 224, a conductive paint formed on the outer surface, or a conductive pattern formed on the outer surface. In an embodiment, the at least one antenna element 224b may be disposed to be embedded during the injection molding of the rear bracket 224. In an embodiment, the at least one antenna element 224b may be configured to transmit or receive a wireless signal in a predetermined frequency band (e.g., a legacy band) by being electrically connected to wireless communication circuitry (e.g., the wireless communication module 192 of FIG. 1) disposed on the first substrate 251. In an embodiment, the camera module 216 and/or the sensor module 217 may be disposed to detect an external environment through the opening 224a or the notch area 224c. In an embodiment, in the second rear surface cover 223, at least an area corresponding to the camera module 216 and/or the sensor module 217 may be transparently processed. In an embodiment, the second rear surface cover 223 may include a through-hole formed in at least an area corresponding to the camera module 216 and/or the sensor module 217. In this case, the through-hole may be covered through a transparent window. In an embodiment, the camera module 216 and/or the sensor module 217 may be configured to operate only when the electronic device 200 is in the slide-out state.

According to an embodiment, the electronic device 200 may include a support bracket 225 disposed in the first space 2101 of the first housing 210. In an embodiment, the support bracket 225 may include a support portion 2252 disposed at one end and having an outer surface formed in a curved shape to support the rear surface of the support member 240, which is bent during a sliding operation transitioning from the slide-out state to the slide-in state. In an embodiment, the support bracket 225 may include a support structure configured to support and fix the driving motor 260 through the motor bracket 260a. In an embodiment, the support bracket 225 may include a battery seating portion 2251 configured to accommodate a battery. In an embodiment, the driving motor 260 may be disposed at an outermost end (e.g., an edge) of the support bracket 225 in the slide-out direction (e.g., the y-axis direction). For example, when assembly of the electronic device 200 is completed, the driving motor 260 may be disposed at a position closest to the first substrate 251 among electronic components disposed in the first housing 210, thereby helping minimize the size and/or the length of a flexible board F1 (e.g., a flexible printed circuit board (FPCB)) electrically connecting the first substrate 251 and the driving motor 260. In an embodiment, the electronic device 200 may include a pair of guide rails 226 disposed on opposite side surfaces of the support bracket 225 to guide opposite ends of the support member 240 in a sliding direction.

According to an embodiment, the first housing 210 may include, in the first extension member 212, an opening 212a (e.g., a through-hole) disposed in an area corresponding to the camera module 216 and/or the sensor module 217 disposed in the second housing 220 when the electronic device 200 is in the slide-in state. In an embodiment, when the electronic device 200 is in the slide-in state, the camera module 216 and/or the sensor module 217 may detect an external environment through the opening 212a formed in the first housing 210. In an embodiment, an area of the first rear surface cover 213 corresponding to the camera module 216 and/or the sensor module 217 may be transparently processed.

According to an embodiment, the electronic device 200 may include, in the first housing 210, a second substrate 252 (e.g., a sub-substrate) and an antenna member 253 disposed between the first extension member 212 and the first rear surface cover 213. In an embodiment, the second substrate 252 and the antenna member 253 may be disposed on at least a portion of the first extension member 212. In an embodiment, the second substrate 252 and the antenna member 253 may be electrically connected to the first substrate 251 via at least one electrical connection member (e.g., an FPCB, a flexible printed circuit board, or an FRC, a flexible RF cable). In an embodiment, the antenna member 253 may include a multi-function coil or multi-function core (MFC) antenna configured to perform a wireless charging function, a near-field communication (NFC) function, and/or an electronic payment function. In an embodiment, the antenna member 253 may be electrically connected to the second substrate 252 and may thus be electrically connected to the first substrate 251 via the second substrate 252. In an embodiment, the second substrate 252 and/or the antenna member 253 may be electrically connected to the first substrate 251 via at least a portion of the flexible board F1 connecting the driving motor 260 and the first substrate 251.

According to an embodiment, the support member 240 may be guided through the guide rails 226 during the slide-in/slide-out operation. In an embodiment, the support member 240 may include multiple bars 241 rotatably coupled to each other and guide protrusions 2411 protruding from opposite ends of each of the multiple bars 241. In an embodiment, the guide rails 226 may include guide slits 2261 formed at positions corresponding to a movement trajectory of the support member 240. In an embodiment, when the support member 240 fixed by being attached to the rear surface of the rollable display 230 is movably coupled to the guide rails 226, the guide protrusions 2411 move along the guide slits 2261, thereby helping reduce a phenomenon in which the rollable display 230 is separated or deformed during operation.

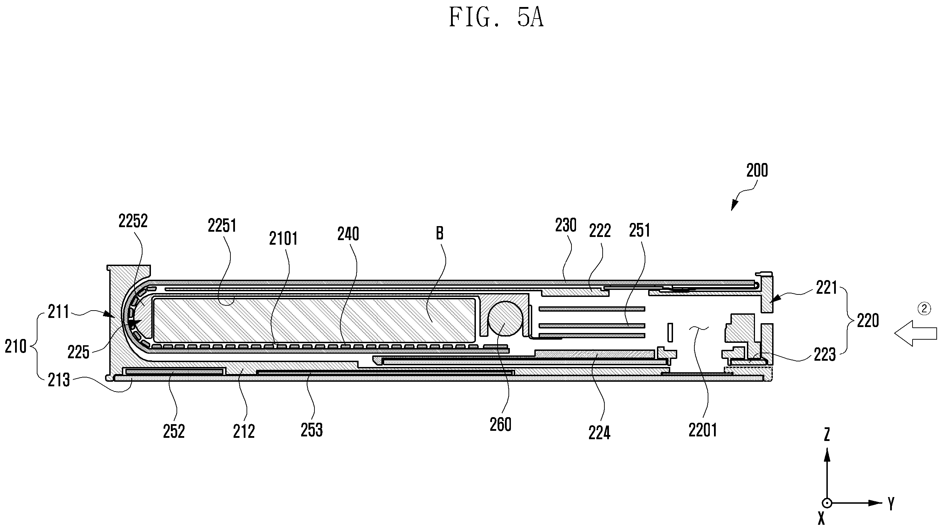

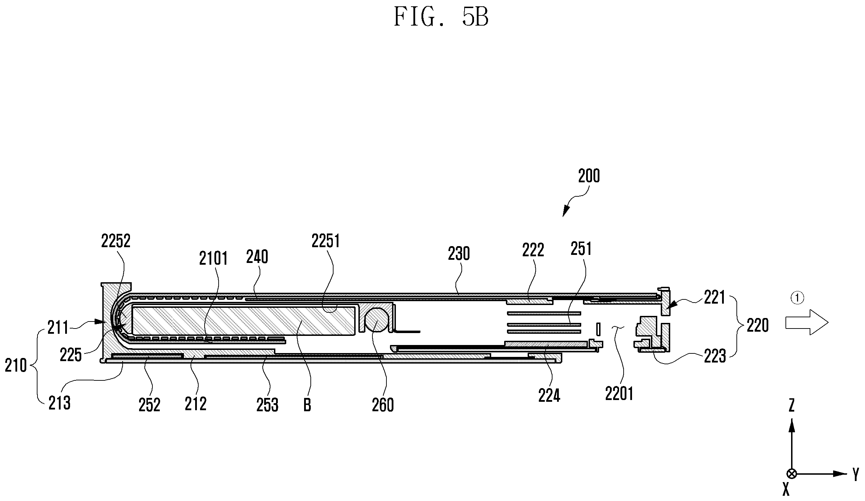

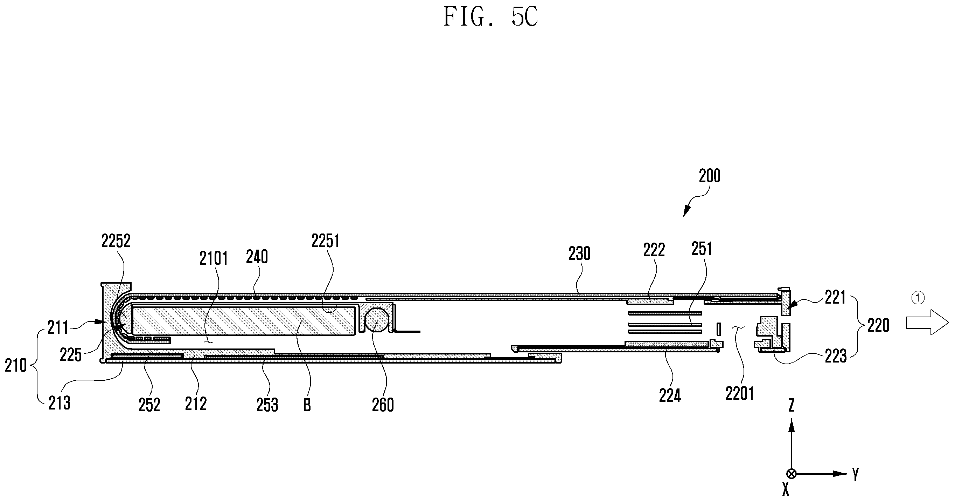

FIG. 5A is a cross-sectional view of an electronic device taken along line 5a-5a of FIG. 2A, according to an embodiment of the disclosure. FIG. 5B is a cross-sectional view of the electronic device in an intermediate state, according to an embodiment of the disclosure. FIG. 5C is a cross-sectional view of the electronic device taken along line 5c-5c of FIG. 3A, according to an embodiment of the disclosure.

In describing the electronic device 200 of FIGS. 5A to 5C, the same reference numerals are assigned to components substantially identical to those of the electronic device 200 of FIG. 4, and a detailed description thereof may be omitted.

Referring to FIGS. 5A to 5C, the electronic device 200 may include a first housing 210 having a first space 2101, a second housing 220 having a second space 2201, a support member 240 connected to the second housing 220 and at least partially accommodated in the first space 2101 in the slide-in state, a rollable display 230 disposed to be supported by at least a portion of the support member 240 and at least a portion of the second housing 220, and a driving motor 260 disposed in the first space 2101 and including a pinion gear (e.g., the pinion gear 261 of FIG. 4) meshed with a rack gear (e.g., the rack gear 2221 of FIG. 4) of the second space 2201. In an embodiment, the driving motor 260 may automatically move the second housing 220 in a slide-in direction (direction ②) or a slide-out direction (direction ①) through meshing between the pinion gear (e.g., the pinion gear 261 of FIG. 4) and the rack gear 2221 (e.g., the rack gear 2221 of FIG. 4).

According to an embodiment, in the slide-in state of the electronic device 200 (the state of FIG. 5A), at least a portion of the second housing 220 may be accommodated in the first space 2101 of the first housing 210. In an embodiment, at least a portion of the rollable display 230 may be accommodated together with the support member 240 in the first space 2101 in a bending manner and may be disposed to be invisible from the outside. In this case, a first display area of the rollable display 230 (e.g., a display area corresponding to the first portion 230a of FIG. 3A) may be visually exposed to the outside.

According to an embodiment, the electronic device 200 may transition from an intermediate state (the state of FIG. 5B) to a slide-out state (the state of FIG. 5C) by controlling driving of the driving motor 260. In some embodiments, the electronic device 200 may be configured to stop at a predetermined intermediate state between the slide-in state and the slide-out state (a free-stop function). In some embodiments, the electronic device 200 may transition to the slide-in state, the intermediate state, or the slide-out state through a user's manipulation in a state in which no driving force is provided to the driving motor 260.

According to an embodiment, at least a portion of the second housing 220 may transition, through driving of the driving motor 260, to a slide-out state in which the at least a portion of the second housing 220 is at least partially moved to the outside from the first housing 210 along a first direction (direction ①). In an embodiment, in the slide-out state of the electronic device 200 (the state of FIG. 5C), the rollable display 230 may be exposed so that a portion slid in into the first space 2101 may be at least partially visible from the outside by moving together with the support member 240 while being supported by the support bracket 225. In this case, a second display area of the rollable display 230, expanded from the first display area (e.g., a display area including the first portion 230a and the second portion 230b of FIG. 3A), may be visually exposed to the outside.

According to an embodiment, the electronic device 200 may include a battery B disposed through a battery seating portion 2251 of the support bracket 225 fixed in the first space 2101 of the first housing 210. In an embodiment, because the battery B is disposed in the first housing 210, a separate driving gap for avoiding interference with surrounding structures due to movement may not be required. Accordingly, the battery B may expand in thickness from the battery seating portion 2251 of the support bracket 225 to approach or contact the rear surface of the support member 240, thereby relatively increasing battery volume, and, by supporting the moving support member 240, may help reduce sagging of the rollable display 230 and improve operational reliability.

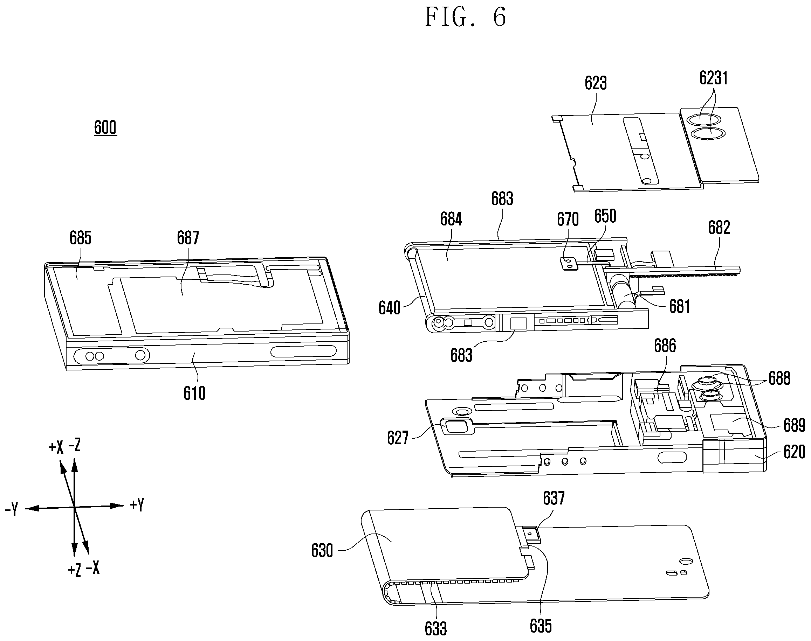

FIG. 6 is an exploded perspective view of an electronic device 600 according to an embodiment of the disclosure.

The electronic device 600 may refer to the electronic device 101 of FIG. 1 or may include at least some of the components of the electronic device 101 illustrated in FIG. 1.

The electronic device 600 may refer to the electronic device 200 of FIG. 4 or may include at least some of the components of the electronic device 200 illustrated in FIG. 4.

In describing the electronic device 600 according to an embodiment of the disclosure, the width direction of the electronic device 600 may refer to an X-axis direction, and the length direction of the electronic device 600 may refer to a Y-axis direction. The height direction of the electronic device 600 may refer to a Z-axis direction.

Referring to FIG. 6, an electronic device 600 according to an embodiment of the disclosure may include a first housing 610, a second housing 620, a flexible display 630, a support member 633, a frame cover 640, a belt 650, a pulley 660 (see

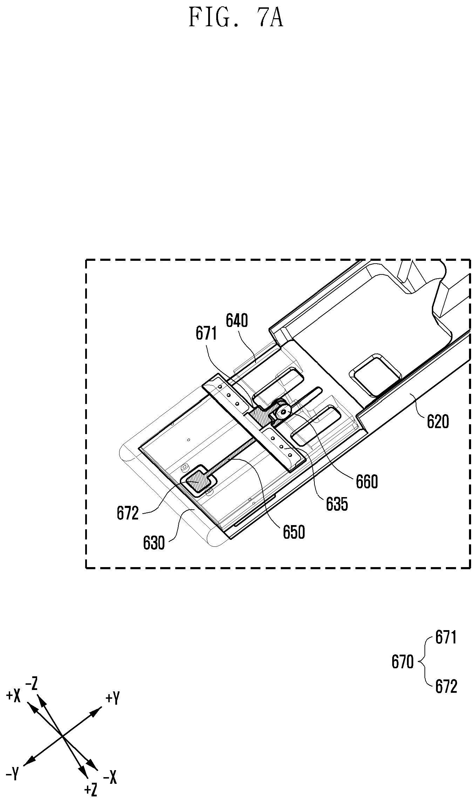

FIG. 7A), a fixing member 670, a rear surface cover 623, a driving motor 681, a rack gear structure 682, a guide rail 683, a battery 684, printed circuit boards 685 and 686, an antenna module 687, a camera module 688, and/or an audio output module 689.

The first housing 610 illustrated in FIG. 6 may refer to the first housing 210 illustrated in FIG. 4 or may include at least some of the components of the first housing 210.

In an embodiment, the first housing 610 may be a component forming an exterior of the electronic device 600.

In an embodiment, the flexible display 630 may be disposed on at least a portion of the first housing 610. The first housing 610 may support the flexible display 630.

In an embodiment, the antenna module 687 and the first printed circuit board 685 may be disposed on at least a portion of the first housing 610.

In an embodiment, the first housing 610 may be an area configured to be gripped by a user of the electronic device 600.

In an embodiment, the first housing 610 may include, therein, a structure for preventing foreign matter from being introduced. For example, the first housing 610 may include a structure for preventing foreign matter from being introduced (e.g., a sweeper) at a position corresponding to an area in which the flexible display 630 is bent.

In an embodiment, the antenna module 687 may transmit a signal or power to the outside (e.g., an external electronic device) or receive a signal or power from the outside.

The second housing 620 illustrated in FIG. 6 may refer to the second housing 220 illustrated in FIG. 4 or may include at least some of the components of the second housing 220.

In an embodiment, the second housing 620 may be movably coupled to the first housing 610. For example, the second housing 620 may be moved with respect to the first housing 610 along the length direction (e.g., the Y-axis direction) of the electronic device 600.

In an embodiment, the second housing 620 may support at least a portion of the flexible display 630.

In an embodiment, at least some of the components of the electronic device 600 may be disposed in the second housing 620. For example, the second printed circuit board 686, the camera module 688, and the audio output module 689 may be disposed in the second housing 620.

In an embodiment, the second housing 620 may be integrally formed with the rear surface cover 623. For example, the second housing 620 according to an embodiment may include the rear surface cover 623 configured to cover a portion of the second housing 620.

In an embodiment, the camera module 688 may capture a still image and a video image. According to an embodiment, the camera module 688 may include one or more lenses, image sensors, image signal processors, or flashes.

In an embodiment, the audio output module 689 may output an audio signal to the outside of the electronic device 600. The audio output module 689 may include, for example, a speaker or a receiver.

The flexible display 630 illustrated in FIG. 6 may refer to the rollable display 230 illustrated in FIG. 4 or may include at least some of the components of the rollable display 230.

In an embodiment, the flexible display 630 may be disposed such that at least a portion thereof is supported by the first housing 610 and/or the second housing 620.

In an embodiment, the flexible display 630 may be an area responsible for input and/or output of the electronic device 600. For example, a user of the electronic device 600 may input a predetermined command to the electronic device 600 by using the flexible display 630. The flexible display 630 may output visual information and display the visual information to the outside of the electronic device 600.

In an embodiment, the display area of the flexible display 630 may be changed according to movement of the second housing 620 relative to the first housing 610.

In an embodiment, the flexible display 630 may be moved according to the sliding operation (e.g., a slide-in operation or a slide-out operation) of the electronic device 600.

In an embodiment, the flexible display 630 may be at least partially bent.

In an embodiment, the support member 633 may be attached to the flexible display 630 and may serve to reinforce the flexible display 630.

In an embodiment, the support member 633 may include a multi-bar assembly configured to support the flexible display 630. For example, the support member 633 may include multiple bars and may be attached to the flexible display 630 using an adhesive. The support member 633 may be connected to the guide rail 683.

In an embodiment, the frame cover 640 may be disposed in the first housing 610.

In an embodiment, at least some of the components of the electronic device 600 may be disposed on the frame cover 640. For example, the battery 684 and the guide rail 683 may be disposed on the frame cover 640.

In an embodiment, the frame cover 640 may serve to support the flexible display 630.

In an embodiment, the battery 684 may supply power to at least one component of the electronic device 600. According to an embodiment, the battery 684 may include, for example, a non-rechargeable primary battery, a rechargeable secondary battery, or a fuel cell.

In an embodiment, the driving motor 681 may be disposed in the second housing 620. For example, the driving motor 681 may be disposed to be fixed to at least a portion of the second housing 620.

In an embodiment, the driving motor 681 may serve to generate rotational force and transmit the rotational force to another component of the electronic device 600.

In an embodiment, the rack gear structure 682 may be disposed to operate in conjunction with the driving motor 681. For example, the driving motor 681 may operate in conjunction with the rack gear structure 682 via a gear (e.g., a pinion gear) meshing with at least a portion of the rack gear structure 682.

In an embodiment, the rack gear structure 682 may be disposed in the second housing 620. By using the rotational force generated by the driving motor 681, the rack gear structure 682 and the second housing 620 in which the rack gear structure 682 is disposed may linearly move.

In an embodiment, the second housing 620 may be moved in a slide-in direction or a slide-out direction with respect to the first housing 610 by using the rotational force of the driving motor 681.

In an embodiment, guide rails 683 may be respectively disposed on opposite sides of the frame cover 640.

In an embodiment, the guide rail 683 may serve to cause the support member 633 disposed on the flexible display 630 to move along a predetermined path.

In an embodiment, the rear surface cover 623 may be disposed to cover at least a portion of the second housing 620. In an embodiment, the rear surface cover 623 may include a camera opening 6231 at a position corresponding to the camera module 688.

In an embodiment, the belt 650 may be connected to the flexible display 630 at one end and connected to the second housing 620 at an opposite end.

In an embodiment, the flexible display 630 may include an end member 635 (e.g., an end bar) positioned at the end thereof. In an embodiment, a first seating portion 637 may be formed in the end member 635.

In an embodiment, the belt 650 may be coupled to fixing members 670 at opposite ends thereof.

In an embodiment, the fixing members 670 coupled to the opposite ends of the belt 650 may be respectively disposed on the flexible display 630 and the second housing 620. For example, one fixing member 670 may be disposed in the first seating portion 637 of the flexible display 630. The other fixing member 670 (e.g., the second fixing member 672 of FIG. 7A) may be disposed in the second seating portion 627 of the second housing 620.

In an embodiment, because the belt 650 is connected to the flexible display 630 and the second housing 620, force (e.g., tension) may be transmitted to the flexible display 630 when the second housing 620 is moved with respect to the first housing 610.

In an embodiment, the belt 650 may transmit tension to the flexible display 630 so that the flexible display 630 does not bulge beyond a predetermined reference during the sliding driving process of the electronic device 600.

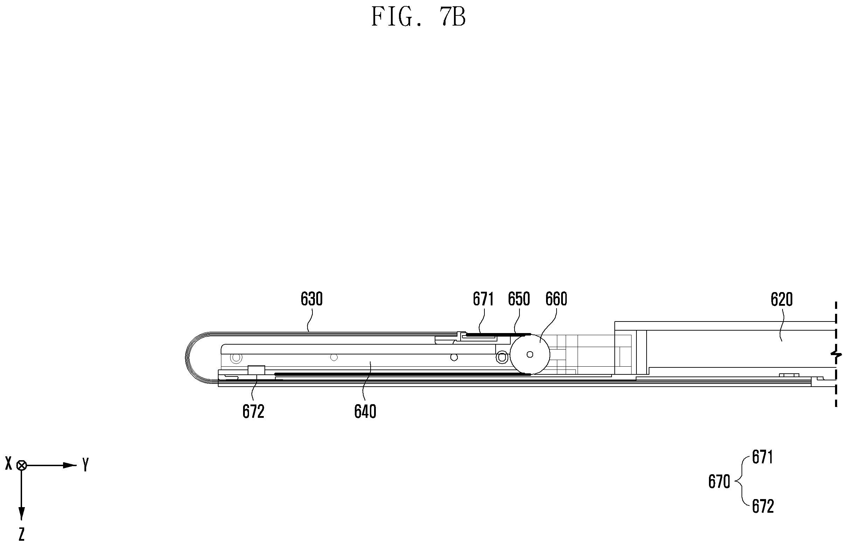

FIGS. 7A and 7B are views illustrating the second housing 620 and the belt 650 in the slide-in state, according to an embodiment of the disclosure.

FIG. 7A is a perspective view illustrating the second housing 620 and the belt 650 in the slide-in state. FIG. 7B is a view illustrating the second housing 620 and the belt 650 in the slide-in state as viewed in the width direction of the electronic device 600 (e.g., the X-axis direction).

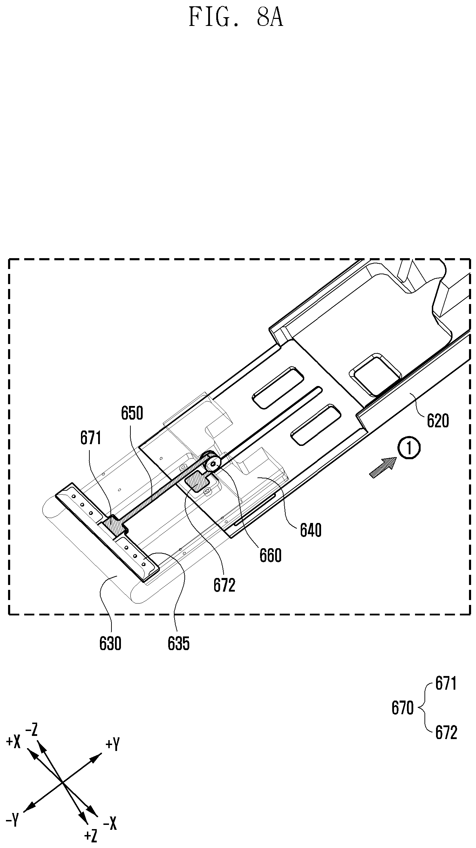

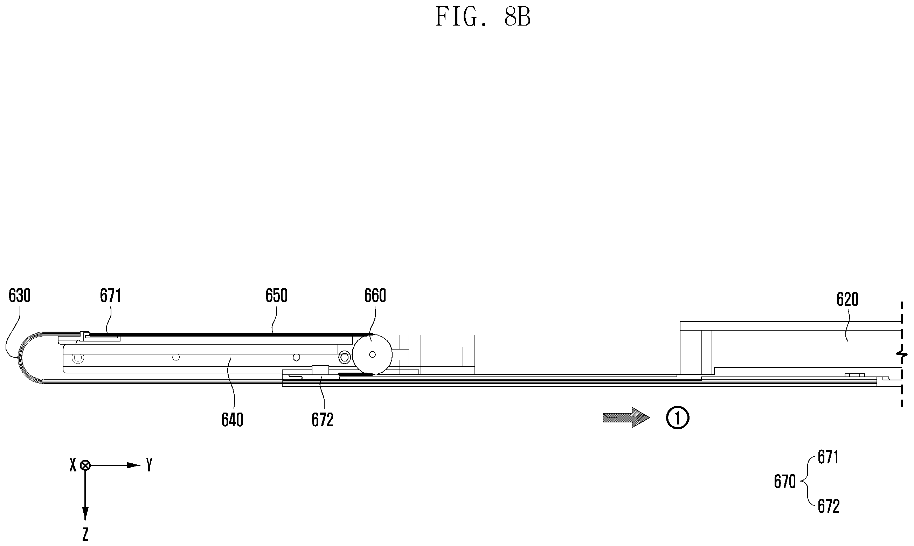

FIGS. 8A and 8B are views illustrating the second housing 620 and the belt 650 in the slide-out state, according to an embodiment of the disclosure.

FIG. 8A is a perspective view illustrating the second housing 620 and the belt 650 in the slide-out state. FIG. 8B is a view illustrating the second housing 620 and the belt 650 in the slide-out state as viewed in the width direction of the electronic device 600 (e.g., the X-axis direction).

In an embodiment, the flexible display 630 may include an end member 635 (e.g., an end bar) positioned at the end thereof. The flexible display 630 may be connected to the belt 650 via the end member 635.

In an embodiment, the fixing member 670 may include a first fixing member 671 and/or a second fixing member 672.

In an embodiment, the belt 650 may be coupled to the first fixing member 671 at one end and coupled to the second fixing member 672 at an opposite end.

In an embodiment, the belt 650 may be at least partially bent. For example, the belt 650 may extend while being at least partially bent between the first fixing member 671 and the second fixing member 672.

Referring to FIGS. 7A, 7B, 8A, and 8B, the belt 650 may be connected to the flexible display 630 and the second housing 620. For example, the belt 650 may be connected, at one end thereof, to the end member 635 of the flexible display 630. The belt 650 may be connected, at the opposite end thereof, to at least a portion of the second housing 620.

In an embodiment, the belt 650 may be disposed such that at least a portion thereof is in contact with the pulley 660. For example, a portion of the bent area of the belt 650 may be disposed to be in contact with the pulley 660. A portion of the bent area of the belt 650 may be disposed to surround at least a portion of the pulley 660.

In an embodiment, the belt 650 may be disposed on at least a portion of the frame cover 640. For example, the belt 650 may be disposed on the central portion (e.g., the central portion in the X-axis direction) of the frame cover 640.

A position at which the belt 650 is disposed on the frame cover 640 may not be limited to the form illustrated in FIGS. 7A and 8A. For example, in an embodiment, the belt 650 may not be disposed on the central portion of the frame cover 640 and may be disposed in areas adjacent to the opposite side surfaces (e.g., the side surfaces in the X-axis direction) of the frame cover 640.

In an embodiment, the belt 650 may be disposed such that at least a portion thereof surrounds the pulley 660. For example, the belt 650 may be disposed such that at least a portion thereof is in contact with the pulley 660 and surrounds a portion of the pulley 660.

In an embodiment, the belt 650 may move together with movement of the second housing 620 and the flexible display 630. For example, referring to FIGS. 7A, 7B, 8A, and 8B, when the second housing 620 is moved in the first direction (direction η), the second fixing member 672 coupled to an end portion of the belt 650 may be moved in the first direction (direction η). When the second housing 620 is moved in the first direction (direction η), the first fixing member 671 may be moved in a direction opposite to the first direction (direction η). When the belt 650 is moved, the pulley 660 in contact with the belt 650 may rotate.

In an embodiment, when the second housing 620 is moved, tension may be applied to the flexible display 630 by the belt 650.

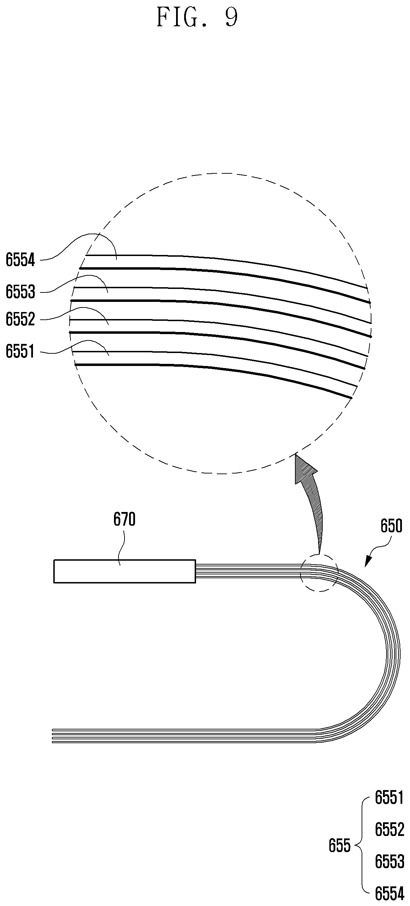

FIG. 9 is a view illustrating a belt 650 according to an embodiment of the disclosure.

FIG. 9 may be a view illustrating the belt 650 coupled to a fixing member 670 according to an embodiment.

The fixing member 670 illustrated in FIG. 9 may refer to the first fixing member 671 of FIG. 7A or may include the first fixing member 671 of FIG. 7A.

In an embodiment, the belt 650 may include at least one metal sheet 655.

In an embodiment, the belt 650 may include at least two metal sheets 655 disposed to overlap each other. For example, the belt 650 may be formed by stacking the at least two metal sheets 655. For example, the belt 650 may be disposed such that at least some portions thereof overlap each other and at least some portions thereof do not overlap each other.

Referring to FIG. 9, the metal sheets 655 may include a first metal sheet 6551, a second metal sheet 6552, a third metal sheet 6553, and/or a fourth metal sheet 6554.

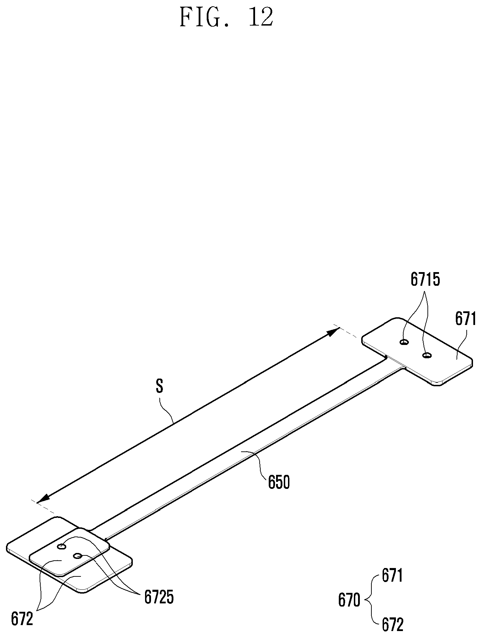

In an embodiment, the length of the metal sheet 655 may refer to a length (e.g., the length S of FIG. 12) by which the metal sheet 655 extends from the first fixing member 671 (see FIG. 12) to the second fixing member 672 (see FIG. 12).

In an embodiment, the metal sheets 655 may be formed such that a metal sheet 655 located farther from the pulley 660 (see FIG. 7A) has a greater length. For example, the second metal sheet 6552 may be formed to have a greater length than the first metal sheet 6551. The third metal sheet 6553 may be formed to have a greater length than the second metal sheet 6552. The fourth metal sheet 6554 may be formed to have a greater length than the third metal sheet 6553.

In an embodiment, a plurality of metal sheets 655 may be formed of the same material.

In an embodiment, the plurality of metal sheets 655 may have the same thickness t.

In an embodiment, the plurality of metal sheets 655 may each have a thickness of 0.03 mm to 0.08 mm. For example, the first metal sheet 6551, the second metal sheet 6552, the third metal sheet 6553, and the fourth metal sheet 6554 may each have a thickness of 0.05 mm.

In an embodiment, at least some of the plurality of metal sheets 655 may have different thicknesses. For example, the first metal sheet 6551 and the second metal sheet 6552 may have a thickness of 0.03 mm, and the third metal sheet 6553 and the fourth metal sheet 6554 may have a thickness of 0.08 mm.

In an embodiment, the belt 650 may be at least partially bent. In an embodiment, because the first metal sheet 6551, the second metal sheet 6552, the third metal sheet 6553, and the fourth metal sheet 6554 each have a small thickness (e.g., a thickness of 0.05 mm), the belt 650 may be easily bent in a flexible manner.

In an embodiment, because the belt 650 is formed by stacking two or more metal sheets 655, strength and rigidity capable of withstanding tension applied to the belt 650 may be secured.

In an embodiment, the lengths Si of the metal sheets 655 may be formed to satisfy Equation 1 below. For example, the length Sᵢ₊₁ of another metal sheet 655 stacked in an outward direction of a particular metal sheet 655 (e.g., a direction away from the pulley 660 (see FIG. 7A)) may be formed to have a value obtained by adding, to the length Sᵢ of the particular metal sheet 655, a value πt obtained by multiplying π by the thickness t of the metal sheet 655. [Equation 1] ${S}_{i + 1} = {S}_{i } + π t$

For example, the length S₂ of the second metal sheet 6552 may have a value obtained by adding, to the length S₁ of the first metal sheet 6551, a value πt obtained by multiplying π by the thickness t of the second metal sheet 6552. The length S₃ of the third metal sheet 6553 may have a value obtained by adding, to the length S₂ of the second metal sheet 6552, a value πt obtained by multiplying π by the thickness t of the third metal sheet 6553. The length S₄ of the fourth metal sheet 6554 may have a value obtained by adding, to the length S₃ of the third metal sheet 6553, a value πt obtained by multiplying π by the thickness t of the fourth metal sheet 6554.

In an embodiment, the thicknesses t of the first metal sheet 6551, the second metal sheet 6552, the third metal sheet 6553, and the fourth metal sheet 6554 may be formed to be the same.

In describing Equation 1, a case in which the metal sheets 655 include four metal sheets 655 has been described by way of an example, but even when the metal sheets 655 include five or more metal sheets 655, lengths of the respective metal sheets 655 may be formed to satisfy Equation 1.

In an embodiment, when the lengths Sᵢ of the metal sheets 655 are formed to satisfy Equation 1, respective metal sheets (e.g., 6551, 6552, 6553, and 6554) included in the belt 650 may not be spaced apart from each other. Because the respective metal sheets (e.g., 6551, 6552, 6553, and 6554) included in the belt 650 are not spaced apart from each other, tension may be distributed to the respective metal sheets (e.g., 6551, 6552, 6553, and 6554), and overall strength and rigidity of the belt 650 may be improved.

In an embodiment, an adhesive member (e.g., bond, double-sided tape, or solder) may not be disposed between at least some areas (e.g., areas in which the fixing member 670 is not disposed) of the respective metal sheets (e.g., 6551, 6552, 6553, and 6554) included in the belt 650. For example, an air gap may be included between the respective metal sheets (e.g., 6551, 6552, 6553, and 6554).

In an embodiment, an adhesive member (e.g., bond, double-sided tape, or solder) may be disposed between or on side surfaces of at least some areas (e.g., areas in which the fixing member 670 is disposed) of the respective metal sheets (e.g., 6551, 6552, 6553, and 6554) included in the belt 650. For example, an adhesive member (e.g., bond, double-sided tape, or solder) may be disposed between or on side surfaces of the respective metal sheets (e.g., 6551, 6552, 6553, and 6554) included in opposite end portions of the belt 650 (e.g., areas in each of which the fixing member 670 is disposed).

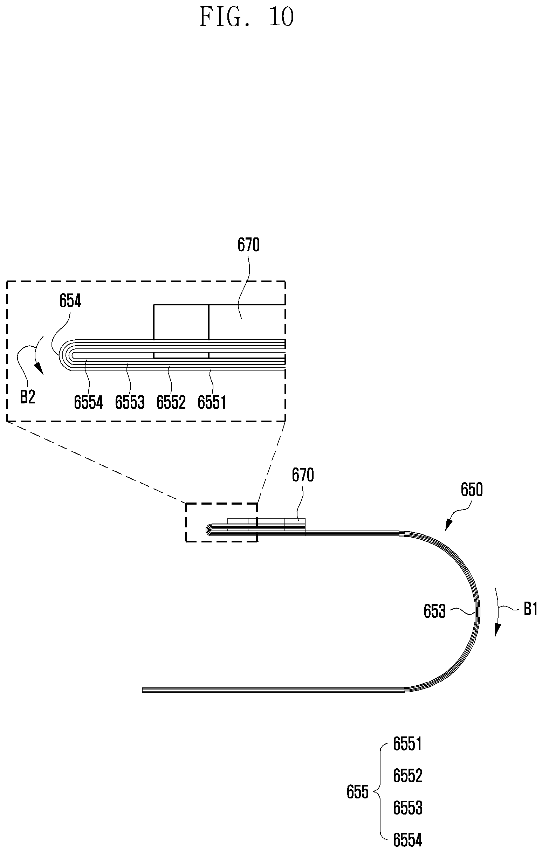

FIG. 10 is a view illustrating the belt 650 including a first bent portion 653 and a second bent portion 654 according to an embodiment of the disclosure.

The fixing member 670 illustrated in FIG. 10 may refer to the first fixing member 671 of FIG. 7A or may include the first fixing member 671 of FIG. 7A.

In an embodiment, the belt 650 may include the first bent portion 653 and the second bent portion 654.

In an embodiment, the first bent portion 653 and the second bent portion 654 may be formed at different positions with respect to the fixing member 670 (e.g., the first fixing member 671 of FIG. 7A). For example, the first bent portion 653 may be formed in one direction of the fixing member 670, and the second bent portion 654 may be formed in the other direction opposite to the one direction of the fixing member 670.

In an embodiment, the first bent portion 653 and the second bent portion 654 may extend while being at least partially bent.

In an embodiment, the belt 650 may be bent in mutually opposite directions at the first bent portion 653 and the second bent portion 654. For example, the first bent portion 653 may be bent in a first bending direction B1, and the second bent portion 654 may be bent in a second bending direction B2 opposite to the first bending direction B1.

In an embodiment, the second bent portion 654 may serve to make lengths of the respective metal sheets 655 of the belt 650 substantially equal to each other. Because the second bent portion 654 is bent in a direction opposite to that of the first bent portion 653, lengths of the first metal sheet 6551, the second metal sheet 6552, the third metal sheet 6553, and the fourth metal sheet 6554 may be substantially equal to each other. For example, in the first bent portion 653 located in one direction of the fixing member 670, because the first metal sheet 6551 is located relatively in an inner direction (e.g., an inner direction of the bent portion), lengths of the first metal sheet 6551, the second metal sheet 6552, the third metal sheet 6553, and the fourth metal sheet 6554 may increase in this order in an area of the belt 650 located in the one direction of the fixing member 670. In the second bent portion 654 located in the other direction of the fixing member 670, because the first metal sheet 6551 is located relatively in an outer direction (e.g., an outer direction of the bent portion), lengths of the fourth metal sheet 6554, the third metal sheet 6553, the second metal sheet 6552, and the first metal sheet 6551 may increase in this order in an area of the belt 650 located in the other direction of the fixing member 670. As a result, the entire lengths of the first metal sheet 6551, the second metal sheet 6552, the third metal sheet 6553, and the fourth metal sheet 6554 in the belt 650 may be substantially equal to each other.

In the belt 650 according to an embodiment, because the lengths of the respective metal sheets 655 included in the belt 650 are equal to each other, manufacture of the belt 650 may be facilitated.

In an embodiment, because the lengths of the respective metal sheets (e.g., 6551, 6552, 6553, and 6554) are formed to be different from each other in the bent portions 653 and 654, the respective metal sheets (e.g., 6551, 6552, 6553, and 6554) included in the belt 650 may not be spaced apart from each other and tension may be distributed to the respective metal sheets (e.g., 6551, 6552, 6553, and 6554), so that the overall strength and rigidity of the belt 650 may be improved.

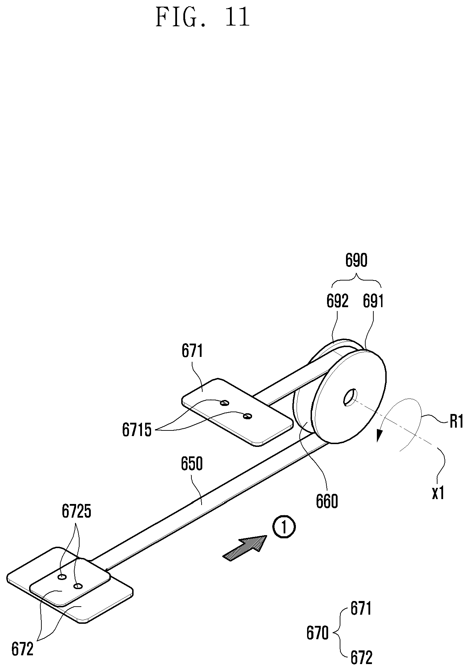

FIG. 11 is a view illustrating the belt 650 and the pulley 660 according to an embodiment of the disclosure.

Referring to FIG. 11, the belt 650 may be disposed such that at least a portion thereof is in contact with the pulley 660. For example, a portion of a bent area of the belt 650 may be disposed to be in contact with the pulley 660.

In an embodiment, the fixing members 670 may include a first fixing member 671 and/or a second fixing member 672.

In an embodiment, the first fixing member 671 may include a first fixing member hole 6715. The first fixing member hole 6715 may be a hole for aligning the first fixing member 671 and the belt 650. For example, the first fixing member hole 6715 may be an alignment hole for coupling the first fixing member 671 and the belt 650 using a welding method.

In an embodiment, the first fixing member 671 may include a plurality of first fixing member holes 6715. For example, referring to FIG. 11, the first fixing member 671 may include two first fixing member holes 6715.

In an embodiment, the second fixing member 672 may include a second fixing member hole 6725. The second fixing member hole 6725 may be a hole for aligning the second fixing member 672 and the belt 650. For example, the second fixing member hole 6725 may be an alignment hole for coupling the second fixing member 672 and the belt 650 using a welding method.

In an embodiment, the second fixing member 672 may include a plurality of second fixing member holes 6725. For example, referring to FIG. 11, the second fixing member 672 may include two second fixing member holes 6725.

In an embodiment, the belt 650 may be coupled to the fixing members 670. For example, the belt 650 may be coupled to the first fixing member 671 at one end and coupled to the second fixing member 672 at an opposite end.

In an embodiment, according to movement of the second housing 620 (see

FIG. 7A), the first fixing member 671 and the second fixing member 672 may be moved, and the belt 650 positioned between the first fixing member 671 and the second fixing member 672 may also be moved together. When the belt 650 is moved, the pulley 660 in contact with the belt 650 may rotate. For example, when the second fixing member 672 is moved in a first direction (direction η), the pulley 660 may rotate in a first rotation direction R1 about a rotation center axis X1. When the second fixing member 672 is moved in a direction opposite to the first direction (direction η), the pulley 660 may rotate in a direction opposite to the first rotation direction R1 about the rotation center axis X1.

In an embodiment, at least one plate 690 may be disposed on the pulley 660. The at least one plate 690 may include a first plate 691 and/or a second plate 692.

In an embodiment, the first plate 691 may be disposed on one side of the pulley 660, and the second plate 692 may be disposed on the other side of the pulley 660.

In an embodiment, the first plate 691 and the second plate 692 may serve to prevent or reduce separation of one area of the belt 650 disposed on the pulley 660 from the pulley 660.

FIG. 12 is a view illustrating the belt 650 and the fixing members 670 according to an embodiment of the disclosure.

In an embodiment, the belt 650 may be coupled to the fixing members 670 at portions thereof. For example, the belt 650 may be coupled to the first fixing member 671 at one end and coupled to the second fixing member 672 at an opposite end.

In an embodiment, the belt 650 may be coupled to the fixing members 670 using a welding method. For example, the belt 650 may be coupled to the first fixing member 671 at one end using a welding method and coupled to the second fixing member 672 at an opposite end using a welding method.

In an embodiment, the first fixing member 671 may include a first fixing member hole 6715. The first fixing member hole 6715 may be an alignment hole for coupling the first fixing member 671 and the belt 650 using a welding method.

In an embodiment, the second fixing member 672 may include a second fixing member hole 6725. The second fixing member hole 6725 may be an alignment hole for coupling the second fixing member 672 and the belt 650 using a welding method.

In an embodiment, the belt 650 may be coupled to the fixing members 670 using a bonding method. For example, a separate adhesive member (not illustrated) may be disposed between the belt 650 and the first fixing member 671 and between the belt 650 and the second fixing member 672, so that the belt 650 and the fixing members 670 may be attached to each other.

Referring to FIG. 12, the length S of the belt 650 according to an embodiment may refer to a length by which the belt 650 extends between the first fixing member 671 and the second fixing member 672.

In an embodiment, the lengths S of respective metal sheets (e.g., 6551, 6552, 6553, and 6554 of FIG. 9) included in the belt 650 may be formed to be different from each other.

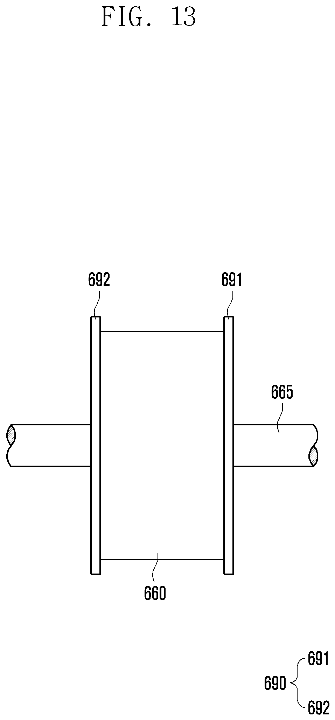

FIG. 13 is a view illustrating a pulley 660 and plates 690 according to an embodiment of the disclosure.

In an embodiment, the electronic device 600 (see FIG. 6) may include a shaft 665 and the plates 690.

In an embodiment, the plates 690 may include a first plate 691 and/or a second plate 692.

In an embodiment, the first plate 691 and the second plate 692 may have substantially the same shape.

Referring to FIG. 13, the plates 690 may be disposed on opposite sides of the pulley 660. For example, the first plate 691 may be disposed on one side of the pulley 660, and the second plate 692 may be disposed on the other side of the pulley 660.

In an embodiment, the plate 690 may be formed as a configuration separated from the pulley 660. For example, the first plate 691 and the second plate 692 may not be formed integrally with the pulley 660, but may be separately manufactured from the pulley 660 and disposed on the pulley 660.

In an embodiment, the shaft 665 may be disposed to extend through the pulley 660 and the plates 690. For example, the shaft 665 may be disposed to extend through the first plate 691, the pulley 660, and the second plate 692.

In an embodiment, the first plate 691, the pulley 660, and the second plate 692 may be disposed at predetermined positions on the shaft 665.

When the pulley 660 and the plates 690 are integrally manufactured, the belt 650 may be damaged due to interference between the belt 650 and the plates 690 during movement of the belt 650. For example, when the pulley 660 and the plates 690 are integrally manufactured, the plates 690 may rotate together with the pulley 660 during interference between the belt 650 and the plates 690, so that damage to the belt 650 may occur.

Because the pulley 660 and the plates 690 according to an embodiment of the disclosure are formed as separate components, even when the belt 650 and the plates 690 interfere with each other, rotation of the plates 690 is reduced, so that damage to the belt 650 may be prevented or reduced.

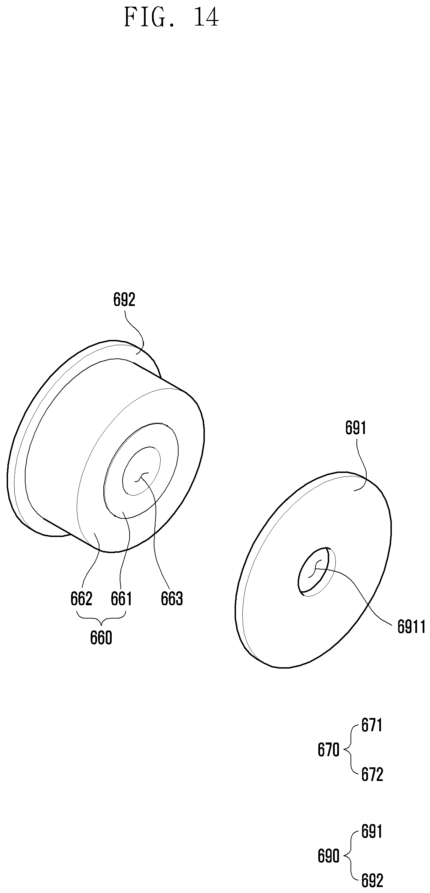

FIG. 14 is a view illustrating a plate 690 to be disposed on the pulley 660 according to an embodiment of the disclosure.

Referring to FIG. 14, the pulley 660 may include an inner area 661 and/or an outer area 662.

In an embodiment, a pulley opening 663 may be formed in the inner area 661 of the pulley 660.

In an embodiment, the shaft 665 (see FIG. 13) may be disposed to extend through the pulley opening 663.

In an embodiment, the inner area 661 may protrude, relative to the outer area 662, in a direction toward the plate 690.

In an embodiment, the inner area 661 of the pulley 660 may be in contact with the plate 690.

Because the pulley 660 according to an embodiment of the disclosure may be in contact with the plate 690 only in the inner area 661, an area in which friction between the pulley 660 and the plate 690 occurs may be reduced.

In an embodiment, the plate 690 may have a greater radius than the pulley 660. For example, the plate 690 may include a circular shape having a greater radius than the pulley 660.

In an embodiment, the plate 690 may include a plate opening (e.g., 6911) therein. For example, the first plate 691 may include a first plate opening 6911, and the second plate 692 may include a second plate opening (not illustrated). In an embodiment, the shaft 665 (see FIG. 13) may be disposed to extend through the first plate opening 6911 and the second plate opening (not illustrated).

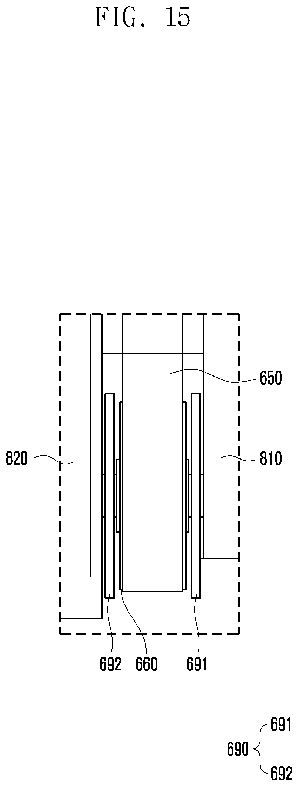

FIG. 15 is a view illustrating a belt 650, a pulley 660, and plates 690 according to an embodiment of the disclosure.

FIG. 15 may be a view illustrating the belt 650, the pulley 660, and the plates 690 disposed in the electronic device 600 (see FIG. 6) by way of an example.

In an embodiment, the pulley 660 and the plates 690 may be disposed between a first mechanical structure 810 and a second mechanical structure 820 of the electronic device 600 (see FIG. 6).

In an embodiment, the first mechanical structure 810 and the second mechanical structure 820 may refer to at least some of the components of the electronic device 600 (see FIG. 6). For example, the first mechanical structure 810 may refer to a part of the rack gear structure 682 (see FIG. 6) of the electronic device 600 (see FIG. 6). The second mechanical structure 820 may refer to a part of the frame cover 640 (see FIG. 6) of the electronic device 600 (see FIG. 6).

In an embodiment, the mechanical structures 810 and 820, the pulley 660, and the plates 690 may be spaced apart from each other. For example, referring to FIG. 15, the first plate 691 may be spaced apart from the first mechanical structure 810 and the pulley 660. The second plate 692 may be spaced apart from the second mechanical structure 820 and the pulley 660.

In the electronic device 600 (see FIG. 6) according to an embodiment of the disclosure, because the mechanical structures 810 and 820, the pulley 660, and the plates 690 are spaced apart from each other, damage to the belt 650 due to interference between the belt 650 and the plates 690 during movement of the belt 650 may be prevented or reduced.

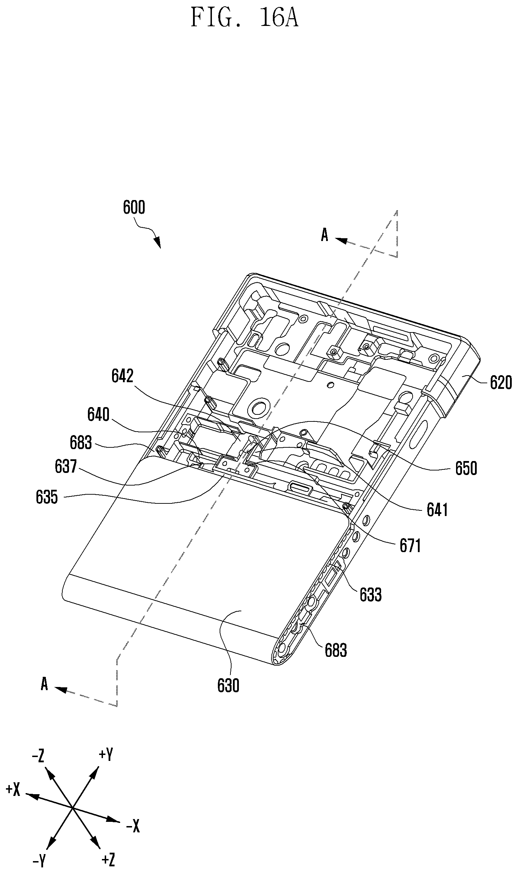

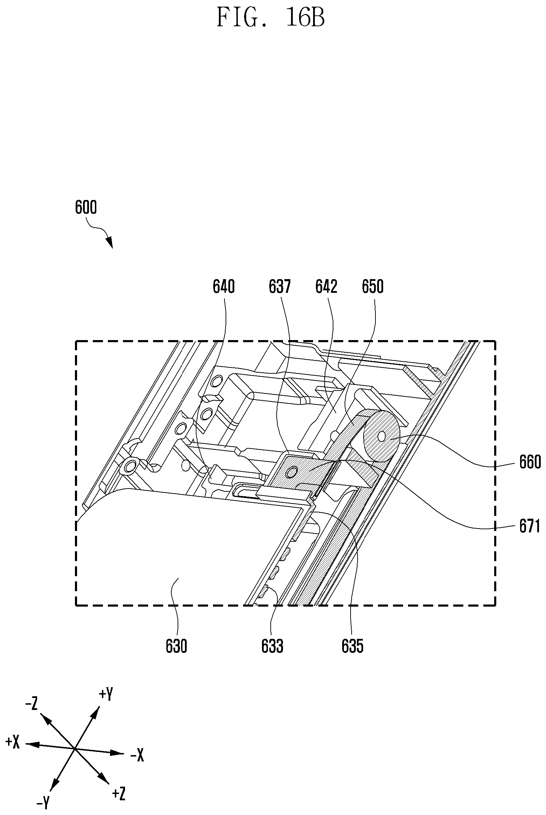

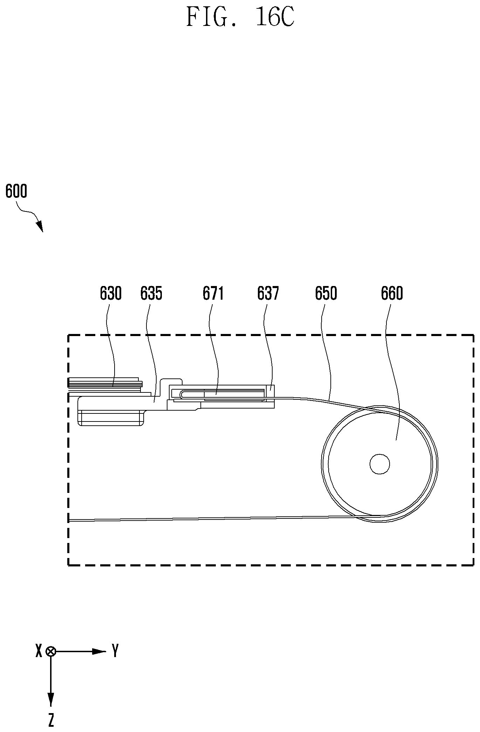

FIGS. 16A, 16B, and 16C are views illustrating the first fixing member 671 and the first seating portion 637 according to an embodiment of the disclosure.

FIG. 16A may be a view illustrating only some of the components of the electronic device 600. For example, FIG. 16A may be a perspective view illustrating, among the components of the electronic device 600, the second housing 620, the flexible display 630, the frame cover 640, the belt 650, the first fixing member 671, and the guide rail 683.

FIG. 16B may be a cross-sectional perspective view illustrating the electronic device 600 cut along line A-A of FIG. 16A. FIG. 16C is a view illustrating the belt 650, the pulley 660, the first fixing member 671, and the first seating portion 637 as viewed in a direction parallel to the length direction of the electronic device 600 (e.g., the X-axis direction).

Referring to FIGS. 16A and 16B, in an embodiment, the pulley 660 may be disposed on at least a portion of the frame cover 640. For example, the pulley 660 may be disposed between a first coupling portion 641 and a second coupling portion 642 of the frame cover 640.

In an embodiment, the first coupling portion 641 of the frame cover 640 may be positioned in one side of the pulley 660, and the second coupling portion 642 of the frame cover 640 may be positioned in the other side of the pulley 660.

In an embodiment, the first fixing member 671 may be disposed on the end member 635 of the flexible display 630. For example, the first fixing member 671 may be disposed in the first seating portion 637 formed in the end member 635.

Referring to FIGS. 16B and 16C, the belt 650 may be disposed such that at least a portion thereof is in contact with the pulley 660. The belt 650 may be disposed such that at least a portion thereof surrounds the pulley 660.

In an embodiment, the belt 650 may be coupled to the first fixing member 671 at an end thereof.

In an embodiment, the flexible display 630 may include an end member 635 supporting an end portion thereof.

In an embodiment, the end member 635 may be separately manufactured from the flexible display 630 and may be disposed at the end portion of the flexible display 630.

In an embodiment, the flexible display 630 may include a space in which the first fixing member 671 is disposed. For example, a first seating portion 637 on which the first fixing member 671 is disposed may be formed in the end member 635 of the flexible display 630.

In an embodiment, the first seating portion 637 may include a wall shape surrounding an outer periphery of the first fixing member 671.

In an embodiment, the first seating portion 637 may serve to prevent the first fixing member 671 from deviating from the first seating portion 637. For example, even when force is applied to the first fixing member 671, relative movement of the first fixing member 671 with respect to the first seating portion 637 may be prevented because a portion of the first seating portion 637 formed in the wall shape supports the first fixing member 671.

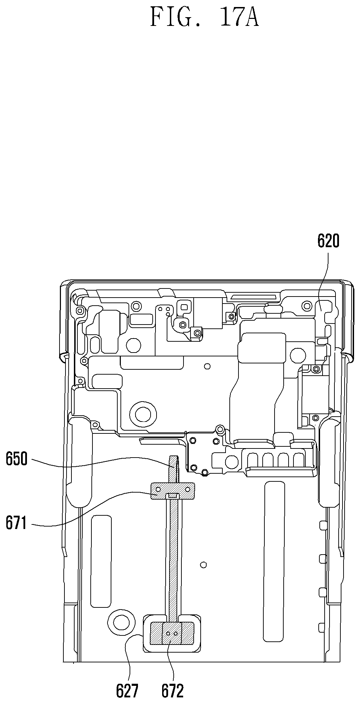

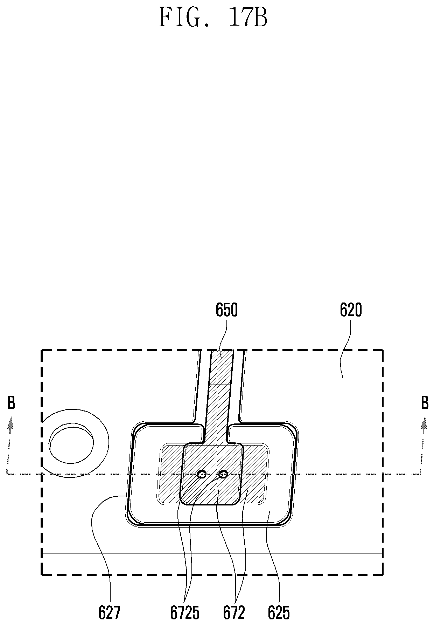

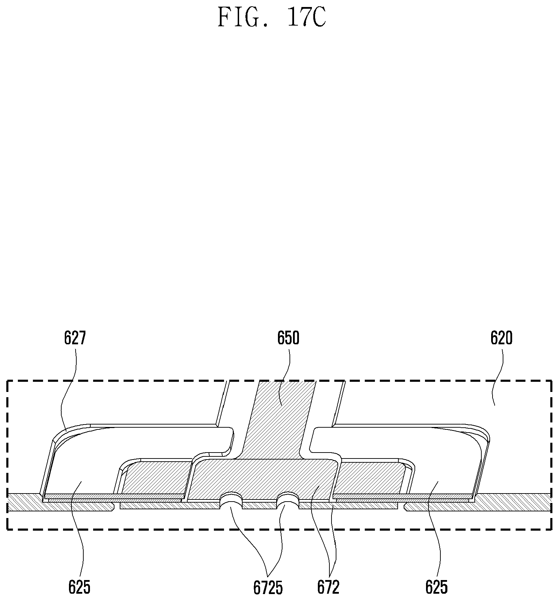

FIGS. 17A, 17B, and 17C are views illustrating the first fixing member 672 and the first seating portion 627 according to an embodiment of the disclosure.

FIG. 17A is a view illustrating the second housing 620, the belt 650, and the fixing members 671 and 672 according to an embodiment of the disclosure. FIG. 17B is an enlarged view illustrating the second fixing member 672 and the second seating portion 627 of FIG. 17A. FIG. 17C is a cross-sectional perspective view illustrating a cross-section taken along line B-B of FIG. 17B.

Referring to FIG. 17A, the belt 650 may be coupled to the first fixing member 671 at one end and coupled to the second fixing member 672 at an opposite end. The belt 650 may extend while being at least partially bent between the first fixing member 671 and the second fixing member 672.

Referring to FIG. 17A, the second fixing member 672 according to an embodiment may be disposed in the second housing 620.

In an embodiment, the second housing 620 may include the second seating portion 627. The second seating portion 627 may include a space in which the second fixing member 672 may be disposed. For example, the second seating portion 627 may be formed in a shape in which a portion of the second housing 620 is concavely recessed to form a space in which the second fixing member 672 may be disposed.

Referring to FIGS. 17B and 17C, the second fixing member 672 according to an embodiment may include a second fixing member hole 6725. The second fixing member hole 6725 may be an alignment hole for coupling the second fixing member 672 and the belt 650 using a welding method.

Referring to FIGS. 17B and 17C, the second housing 620 according to an embodiment may include a filling member 625.

In an embodiment, the second fixing member 672 and the filling member 625 may be disposed in the second seating portion 627.

In an embodiment, the filling member 625 may be disposed to cover at least a portion of the second fixing member 672 and fill a space between the second fixing member 672 and the second seating portion 627.

FIGS. 17A, 17B, and 17C may be views in which an area of the filling member 625 overlapping the second fixing member 672 is transparently illustrated.

In an embodiment, the filling member 625 may serve to position the second fixing member 672 at a predetermined position in the second seating portion 627.

In an embodiment, the second seating portion 627 and the filling member 625 may serve to prevent the second fixing member 672 from deviating from the second seating portion 627. For example, even when force is applied to the second fixing member 672, relative movement of the second fixing member 672 with respect to the second seating portion 627 may be prevented because the second seating portion 627 and the filling member 625 support the second fixing member 672.

In an embodiment, the second fixing member 672 may be disposed in the second seating portion 627 without the filling member 625. In an embodiment, the second seating portion 627 and the second fixing member 672 may be formed such that a perimeter of the second seating portion 627 substantially corresponds to a perimeter of the second fixing member 672 so as to allow the second fixing member 672 to be fixed in the second seating portion 627 in a fitted form even without the filling member 625. When the second fixing member 672 is fixed in the second seating portion 627 in a fitted form, relative movement of the second fixing member 672 with respect to the second seating portion 627 may be prevented.

In an embodiment, the second seating portion 627 may include a wall shape surrounding an outer periphery of the second fixing member 672.

In an embodiment, the second seating portion 627 may serve to prevent the second fixing member 672 from deviating from the second seating portion 627. For example, even when force is applied to the second fixing member 672, relative movement of the second fixing member 672 with respect to the second seating portion 627 may be prevented because a portion of the second seating portion 627 formed in the wall shape directly or indirectly supports the second fixing member 672.

When the belt is formed by stacking metal sheets in two or more layers to secure strength and rigidity of the belt, the metal sheets may be spaced apart from each other due to a difference in length between the metal sheets. As the respective metal sheets are spaced apart from each other, a difference in tension acting on the respective metal sheets may occur. In addition, during a driving process of the belt, damage to the belt may occur due to interference between the belt and a separation prevention structure of the pulley.

An electronic device 600 according to an embodiment of the disclosure may include a housing 610, 620 including a first housing 610 and a second housing 620 movably coupled to the first housing 610, a flexible display 630 disposed to be at least partially supported by the second housing 620 and having a display area variable according to movement of the second housing 620 relative to the first housing 610, a belt 650 connected to the flexible display 630 at one end and connected to the second housing 620 at an opposite end, and a pulley 660 disposed to be in contact with at least a portion of the belt 650. The belt 650 may include at least two metal sheets 655 disposed to overlap each other, and the at least two metal sheets 655 may have different lengths from each other.

In an embodiment, the at least two metal sheets 655 may be formed such that a metal sheet 655 located farther from the pulley 660 has a greater length.

The electronic device 600 according to an embodiment of the disclosure may secure strength and rigidity of the belt 650 by stacking a plurality of metal sheets 655 to form the belt 650.

In an embodiment, the electronic device 600 may include a first fixing member 671 coupled to the belt 650 at the one end of the belt 650 and a second fixing member 672 coupled to the belt 650 at the opposite end of the belt 650.

In an embodiment, the belt 650 may extend while being at least partially bent between the first fixing member 671 and the second fixing member 672.

In an embodiment, the at least two metal sheets 655 may be formed such that, as a metal sheet 655 is located farther from the pulley 660, the length thereof extending between the first fixing member 671 and the second fixing member 672 is greater.

The electronic device 600 according to an embodiment of the disclosure may prevent or reduce the metal sheets 655 from being spaced from each other by configuring lengths of the stacked metal sheets 655 to be different from each other.

In an embodiment, the belt 650 may include a first metal sheet 6551 at least partially disposed on the pulley 660 and a second metal sheet 6552 stacked on the first metal sheet 6551.

In an embodiment, the length of the second metal sheet 6552 may be formed as a value obtained by adding, to the length of the first metal sheet 6551, a value obtained by multiplying the thickness of the second metal sheet 6552 by pi.

In an embodiment, the belt 650 may include a first bent portion 653 formed in one direction of the first fixing member 671 and a second bent portion 654 formed in the other direction opposite to the one direction of the first fixing member 671.

In an embodiment, the first bent portion 653 and the second bent portion 654 may be bent in directions opposite to each other.

In an embodiment, the electronic device 600 may include a shaft 665 passing through the pulley 660 and a plate 690 having a radius greater than that of the pulley 660 and configured to be separated from the pulley 660. The shaft 665 passes through the plate 690.

In an embodiment, in regard to the plate, the electronic device may include a first plate 691 disposed in one side of the pulley 660 and a second plate 692 disposed in the other side of the pulley 660.

In an embodiment, one area of the belt 650 disposed on the pulley 660 may be positioned between the first plate 691 and the second plate 692, and separation thereof from the pulley 660 by the first plate 691 and the second plate 692 may be prevented.

The electronic device 600 according to an embodiment of the disclosure may prevent or reduce damage to the belt 650 due to interference between the belt 650 and a separation prevention structure (e.g., the plate 690) by applying the separation prevention structure (e.g., the plate 690) formed as a separate configuration from the pulley 660.

In an embodiment, the electronic device 600 may include a first seating portion 637 formed at an end of the flexible display 630 and in which the first fixing member 671 is disposed, and a second seating portion 627 formed in at least a portion of the second housing and in which the second fixing member 672 is disposed.

In an embodiment, the first seating portion 637 may surround an outer periphery of the first fixing member 671 and may prevent the first fixing member 671 from moving relative to the first seating portion 637.

In an embodiment, the second seating portion 627 may surround an outer periphery of the second fixing member 672 and may prevent the second fixing member 672 from moving relative to the second seating portion 627.

In an embodiment, the belt 650 may be coupled to the first fixing member 671 and the second fixing member 672 using a welding method.

In an embodiment, the at least two metal sheets 655 may each have a thickness of 0.03 mm to 0.08 mm and may be formed of the same material.

In an embodiment, the flexible display 630 may be configured to receive tension via the belt 650.

A belt structure of an electronic device according to an embodiment of the disclosure may include a belt 650 extending while being at least partially bent and including at least two metal sheets 655, a pulley 660 disposed to be in contact with at least a portion of the belt 650, a first fixing member 671 coupled to the belt 650 at one end of the belt 650, and a second fixing member 672 coupled to the belt 650 at an opposite end of the belt 650. The at least two metal sheets 655 may be formed such that lengths thereof extending between the first fixing member 671 and the second fixing member 672 differ from each other.

In an embodiment, the at least two metal sheets 655 may be formed such that, as a metal sheet 655 is located farther from the pulley 660, a length thereof extending between the first fixing member 671 and the second fixing member 672 is greater.

Technical problems to be solved in the disclosure are not limited to the above-mentioned technical problems, and other technical problems not mentioned above will be clearly understood by those ordinarily skilled in the art to which the disclosure pertains.

Effects obtainable in the disclosure are not limited to the above-mentioned effects, and other effects not mentioned above will be clearly understood by those ordinarily skilled in the art to which the disclosure pertains.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration.

According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (600) comprising:
a housing (610, 620) comprising a first housing (610) and a second housing (620) movably coupled to the first housing;
a flexible display (630) disposed to be at least partially supported by the second housing, wherein a display area of the flexible display is variable according to movement of the second housing relative to the first housing;
a belt (650) connected to the flexible display at one end and connected to the second housing at an opposite end; and
a pulley (660) disposed to contact at least a part of the belt,
wherein the belt comprises at least two metal sheets (655) disposed to overlap each other, and
wherein the at least two metal sheets have different lengths from each other.

2. The electronic device of claim 1, wherein the at least two metal sheets are formed such that a metal sheet located farther from the pulley has a greater length.

3. The electronic device of claim 1, further comprising:
a first fixing member (671) coupled to the belt at the one end of the belt; and
a second fixing member (672) coupled to the belt at the opposite end of the belt,
wherein the belt extends while being bent at least partially between the first fixing member and the second fixing member, and
wherein the at least two metal sheets are formed such that a metal sheet located farther from the pulley has a greater length extending between the first fixing member and the second fixing member.

4. The electronic device of claim 3, wherein the belt comprises:
a first metal sheet (6551) at least partially disposed on the pulley, and
a second metal sheet (6552) stacked on the first metal sheet,
wherein a length of the second metal sheet is determined to be a value obtained by adding, to a length of the first metal sheet, a value obtained by multiplying a thickness of the second metal sheet by pi.

5. The electronic device of claim 3, wherein the belt comprises:
a first bent portion (653) formed in one direction of the first fixing member, and
a second bent portion (654) formed in the other direction opposite to the one direction of the first fixing member,
wherein the first bent portion and the second bent portion are bent in directions opposite to each other.

6. The electronic device of claim 1, further comprising:
a shaft (665) penetrating the pulley; and
at least one plate (690) having a radius greater than that of the pulley and configured to be separated from the pulley, the shaft passing through the plate.

7. The electronic device of claim 6, wherein the at least one plate comprises:
a first plate (691) disposed in one side of the pulley; and
a second plate (692) disposed in another side of the pulley.

8. The electronic device of claim 7, wherein one area of the belt disposed on the pulley is positioned between the first plate and the second plate, and is prevented by the first plate and the second plate from being separated from the pulley.

9. The electronic device of claim 3, further comprising:
a first seating portion (637) formed at an end of the flexible display, wherein the first fixing member is disposed in the first seating portion; and
a second seating portion (627) formed in at least a portion of the second housing, wherein the second fixing member is disposed in the second seating portion.

10. The electronic device of claim 9, wherein the first seating portion surrounds an outer periphery of the first fixing member and prevents the first fixing member from moving relative to the first seating portion, and
wherein the second seat portion surrounds an outer periphery of the second fixing member and prevents the second fixing member from moving relative to the second seating portion.

11. The electronic device of claim 3, wherein the belt is coupled to the first fixing member and the second fixing member by using a welding method.

12. The electronic device of claim 1, wherein the at least two metal sheets each have a thickness of 0.03 mm to 0.08 mm and are formed of a same material.

13. The electronic device of claim 1, wherein the flexible display is configured to receive tension via the belt.

14. A belt structure of an electronic device, comprising:
a belt (650) extending while being at least partially bent and comprising at least two metal sheets (655);
a pulley (660) disposed to be in contact with at least a portion of the belt;
a first fixing member (671) coupled to the belt at one end of the belt; and
a second fixing member (672) coupled to the belt at an opposite end of the belt,
wherein the at least two metal sheets are formed such that lengths thereof extending between the first fixing member and the second fixing member differ from each other.

15. The belt structure of an electronic device of claim 14, wherein the at least two metal sheets are formed such that a metal sheet located farther from the pulley has a greater length extending between the first fixing member and the second fixing member.
